(19) Europäisches Patentamt
European Patent Office
Office européen des brevets

(11) EP 2 289 108 B1

(12) **EUROPEAN PATENT SPECIFICATION**

(45) Date of publication and mention
of the grant of the patent:
**10.05.2017 Bulletin 2017/19**

(21) Application number: **09763354.9**

(22) Date of filing: **07.06.2009**

(51) Int Cl.:
*H01L 31/02* (2006.01)      *H01L 31/06* (2012.01)
*H01L 31/052* (2014.01)     *H02S 40/44* (2014.01)
*H01L 31/054* (2014.01)     *C25B 15/02* (2006.01)
*C25B 1/00* (2006.01)

(86) International application number:
**PCT/US2009/046531**

(87) International publication number:
**WO 2009/152063 (17.12.2009 Gazette 2009/51)**

(54) **BANDGAP-SHIFTED SEMICONDUCTOR SURFACE AND APPARATUS**

HALBLEITEROBERFLÄCHE MIT BANDLÜCKENVERSATZ UND VORRICHTUNG

SURFACE SEMI-CONDUCTRICE À BANDE INTERDITE DÉCALÉE ET APPAREIL

(84) Designated Contracting States:
**AT BE BG CH CY CZ DE DK EE ES FI FR GB GR
HR HU IE IS IT LI LT LU LV MC MK MT NL NO PL
PT RO SE SI SK TR**

(30) Priority: **10.06.2008 US 136716
10.06.2008 US 136736**

(43) Date of publication of application:
**02.03.2011 Bulletin 2011/09**

(73) Proprietor: **Nanoptek Corporation
Maynard, MA 01754 (US)**

(72) Inventors:
 • **GUERRA, John, M.
Concord
MA 01742 (US)**
 • **THULIN, Lukas, M.
Arlington
MA 02474 (US)**
 • **CHANDEKAR, Amol, N.
Lowell, MA 01854 (US)**

(74) Representative: **Cole, David John
46 Kirkhill Gardens
West Greenlees Estate
Cambuslang
Glasgow G72 8EZ (GB)**

(56) References cited:
**KR-A- 19980 060 595     KR-A- 20070 118 064
KR-B1- 100 576 081       US-A- 2 874 102
US-A- 5 578 140          US-A1- 2005 103 639
US-B1- 6 344 127**

• **HARTIG K J ET AL: "Production and testing
methods of different TiO2 photoanodes",
INTERNATIONAL JOURNAL OF HYDROGEN
ENERGY, ELSEVIER SCIENCE PUBLISHERS
B.V., BARKING, GB, vol. 11, no. 12, 16 May 1986
(1986-05-16), pages 773-781, XP025450495, ISSN:
0360-3199, DOI: 10.1016/0360-3199(86)90173-4
[retrieved on 1986-01-01]**

EP 2 289 108 B1

## Description

This invention relates to a process for producing a titania electrode, a photo-reactor core assembly means for carrying out a photo-induced reaction using a titania electrode produced by this process, and a multi-core photo-reactor means comprising a plurality of the photo-reactor core assembly means joined by a common manifold. The titania electrode produced by the process of the invention has a bandgap-shifted semiconductor surface.

For general background information relating to this invention see:

1. www.colorado.edu/~bart/book/solar.htm: Bart J. Van Zeghbroeck, 1997, Chapter 4.8 (Photodiodes and Solar Cells) and Chapter Section 2.2.5 (Temperature and stress dependence of the energy bandgap).

2. J. G. Mavroides, J. A. Kafalas, and D. F. Kolesar, "Photoelectrolysis of water in cells with SrTiO3 anodes," Applied Physics Letters, Vol. 28, No. 5, 1 March 1976, and references therein.

3. A. Fujishima and K. Honda, Nature, 238, 37 (1972)

4. O. Khaselev and J. Turner, "A Monolithic Photovoltaic-Photoelectrochemical Device for Hydrogen Production via Water Splitting," Science, Vol. 280, 17 April, 1998.

5. P. J. Sebastian, M. E. Calixto, and R. N. Bhattacharya, Electrodeposited CIS and CIGS thin film photocatalysts for hydrogen production by photoelectrolysis.

6. T. Gerfin, M. Graetzel and L. Walder, Progr. Inorg. Chem., 44, 345-393 (1997), Molecular and Supramolecular Surface Modification of Nanocrystalline TiO2 films: Charge-Separating and Charge-Injecting Devices.

7. Guerra, J. M., *Storage Medium Having a Layer of Micro-Optical Lenses Each Lens Generating an Evanescent Field,* U.S. Patent No. 5,910,940, June 8, 1999.

8. Guerra, J. M., *Absorption Solar Heating and Storage System,* U.S. Patent No. 4,269,170, May 26, 1981.

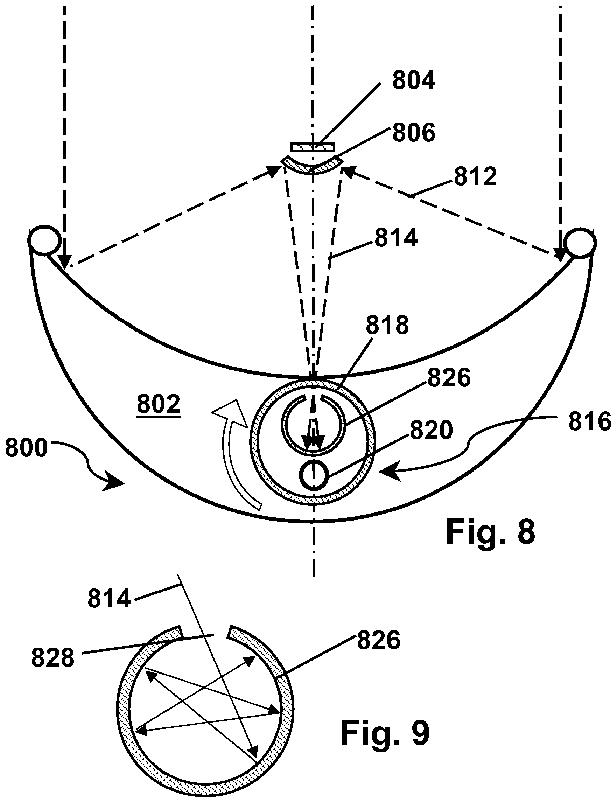

9. Guerra, J. M., Photon tunneling microscopy applications, MRS Proceedings Volume 332, Determining Nanoscale Physical Properties of Materials by Microscopy and Spectroscopy, M. Sarikaya, H. K. Wickramasinghe and M. Isaacson, editors. Page 457, Figure 8b shows tensile stress fissures in diamond-like carbon coating on a silicon substrate. Figure 9a shows adhesion failure due to compressive stresses in a magnesium fluoride thin film coating on an acrylic substrate.

10. Guerra, J. M., *Storage Medium Having a Laser of Micro-Optical Lenses Each Lens Generating an Evanescent Field (application title: Optical Recording Systems and Media with Integral Near-Field Optics),* U.S. Patent No. 5,910,940, June 8, 1999. Assigned to Polaroid Corp.

11. Guerra, J. M. and D. Vezenov, Method of fabrication of sub-micron spherical micro-lenses. Patent Applied For 4/12/01.

12. Guerra, J. M. et al, "Embedded nano-optic media for near-field high density optical data storage: modeling, fabrication, and performance," Proceedings, Optical Data Storage Conference, SPIE, April, 2001.

13. Guerra, J. M. et al, "Near-field optical recording without low-flying heads," ISOM Technical Digest, Taipei, 2001.

14. Guerra, J. M. et al, "Near-field optical recording without low-flying heads: Integral Near-Field Optical (INFO) Media," Japanese Journal of Applied Physics, scheduled publication March 2002

15. J. M. Bennett et al, "Comparison of the properties of titanium dioxide films prepared by various techniques," Appl. Opt. 28, 3303-3317 (1989)

16. H. T. Tien and A. L. Ottova, "Hydrogen generation from water using semiconductor septum electrochemical photovoltaic (SC-SEP) cells," Current Topics in Biophysics 2000, 25(1), 39-60. Modeled on nature's photosynthetic thylakoid membrane.

The ills of our carbon-based energy are well-known and the emergence of hydrogen as a future fuel of choice are discussed at length in U.S. Patent No. 7,485,799 to which the reader is referred for further details. This patent explains how bandgap-shifted semiconductor surfaces, especially titania surfaces, can by useful as photoactive and photocatalytic surfaces. The patent also describes a method of forming such surfaces by depositing thin films of titania and other materials on nano-structured substrates. The present invention provides (a) an improved method for forming photoactive titania electrodes; (b) an improved apparatus using photoactive semiconductor electrodes to carry out photo-induced reactions.

This invention provides a process for producing a titania electrode, the process comprising:

(a) subjecting titanium metal to an acid etchant; and
(b) oxidizing at least part of etched titanium to titania by at least one of (i) anodizing the titanium in an anodizing solution, and (ii) heating the titanium in an oxygen-containing atmosphere.

The process of the invention is characterized in that step (a) forms a titanium nano-structured surface on the titanium metal, said nano-structured surface having nanostructures of mean diameter about 100 nm and with high aspect ratio of at least 1:1, the nanostructures being spaced apart from one another, and in that the titania film produced in step (b) is stressed by the nanostructures, the stress causing the titania film to have a lower bandgap than unstressed titania.

In this process, the titanium metal used may be an impure form containing not more than about 99.6 per cent titanium by weight, for example Grade 1 titanium having the following specification by weight:

C 0.1 % maximum
Fe 0.2 % maximum
H 0.015 % maximum
N 0.03 % maximum
O 0.18 % maximum
Ti 99.5 % minimum, up to about 99.6 %.

or Grade 2 titanium having the following specification by weight:

C 0.1 % maximum
Fe 0.3 % maximum
H 0.015 % maximum
N 0.03 % maximum
O 0.25 % maximum
Ti 99.2 % minimum, up to about 99.6 %.

The titanium metal used may be in the form of a foil, sheet or film from about 0.1 to about 1 mm thick.

Step (a) of the process, in which the nano-structures are formed, may be effected using sulfuric acid having a concentration of at least about 93 per cent by weight at a temperature of about 60 to about 100°C. In a preferred from of the process, the sulfuric acid has a concentration in the range of about 93 to about 98 per cent by weight and the acid etching is effected at a temperature of about 60 to about 70°C. The acid etching may be carried out for a period of from about 60 to about 600 seconds from the onset of visible bubbling. In a preferred form of the process, the etching time is 360 seconds. Alternatively, the acid etching may be carried out using hydrochloric acid and the titanium metal sonicated after the acid etching. Etching with hydrochloric acid may be carried out for a period of from 5 to 30 minutes at a temperature of 50 to 60°C.

Step (b) of the process, in which the titania of substantially anatase morphology is formed, may be effected by anodizing in an aqueous medium having a pH in the range of about 1.5 to about 2.5 and at a temperature of about 60 to about 100°C. The anodizing may be effected at a maximum voltage of from about 70 to about 100 Volts. The anodizing may also be effected at a voltage which increases with time, for example the voltage may increase with time substantially according to the equation:

$$V = V_{Final}\left(1 - e^{-at}\right)$$

where a is an arbitrary constant.

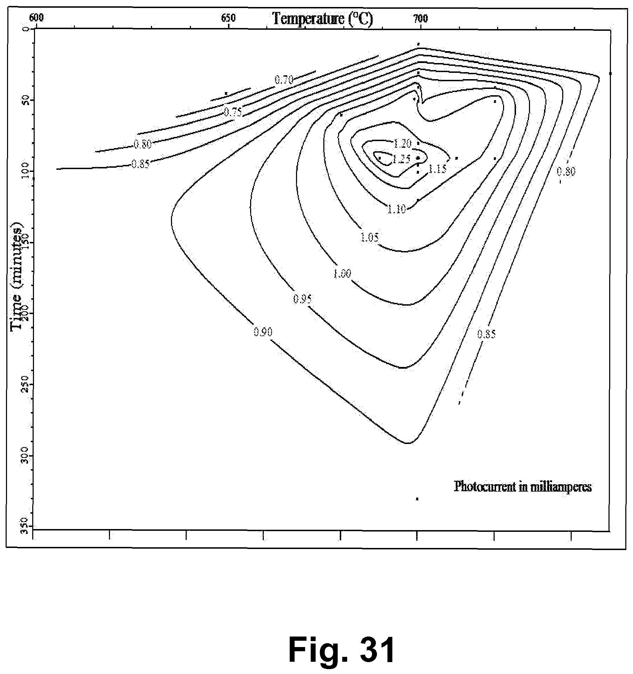

Alternatively, the titania formation in step (b) may be effected by heat oxidizing the titanium at a temperature of at least about 630°C for a period of not more than about 100 minutes, and preferably at a temperature of about 635 to 735°C for a period of about 90 to about 30 minutes. The variation of the photoactivity of the resultant titania electrode with the time and temperature used in the heat oxidation step is somewhat complex and is discussed in detail below with reference to Figure 31. The heat oxidation may be effected in air to which additional oxygen has been added. In a preferred form of the process, the heat oxidation is effected by placing the etched titanium electrode into a tube oven that contains an argon atmosphere with oxygen at less than 1 ppm and is operating at the preferred oxidation temperature described above. A vacuum is applied to remove some or all of the argon, and subsequently oxygen is introduced to a percentage of 20% to 100% and oxidation of the titanium electrode continues for the preferred times described above.

This invention also provides a photo-reactor core assembly means for carrying out at least one photo-induced reaction, the photo-reactor core assembly means comprising at least one photoactive titania electrode produced by the process of the invention, said photoactive titania electrode being provided with louver openings; at least one counter-electrode, at least one septum separating said counter-electrode from said photoactive titania electrode; electrolyte; and at least one liquid-tight container, at least a portion of which is transparent to at least the electromagnetic wavelengths absorbed by said photoactive titania electrode, so as to provide immersion and containment of said photoactive electrode, counter-electrode, and septum in said electrolyte, and to further contain the reaction products developed at said photoactive titania electrode and counter-electrode.

This photo-reactor core assembly means may further comprise:

a primary reflector arranged to concentrate radiation incident thereon to a primary focus;
a secondary reflector or scattering means disposed at or adjacent the primary focus and arranged to direct radiation incident thereon to a secondary focus; and photovoltaic means for converting radiation to electricity;
,wherein one of the photovoltaic means and the photo-reactor means is disposed at or adjacent the primary focus, and the other of the photovoltaic means and the photo-reactor means is disposed at or adjacent the secondary focus.
and wherein the photovoltaic means uses a first wavelength range for converting radiation to electricity and the photo-reactor means uses a second wavelength range at least part of which differs from the first wavelength range, and wherein the secondary reflector or scattering means comprises a wavelength selective reflector or scattering means arranged to reflect or scatter one of the first and second wavelength ranges to the secondary focus.
and wherein the photo-reactor core assembly means comprises a counter-electrode in addition to the photoactive electrode the apparatus further comprising conductors connecting the photovoltaic means to the counter-electrode and photoactive electrode so that the voltage generated by the photovoltaic means is applied as a bias voltage across the counter-electrode and photoactive electrode.

Finally, this invention provides a multi-core apparatus photo-reactor means comprising a parallel and coplanar elongate plurality of photo-reactor core assembly means of the invention joined by at least one common manifold.

The structure and operation of the invention, and advantages thereof, may be understood by reading the detailed description to follow in connection with the drawings in which unique reference numerals have been used throughout for each part and wherein:

Figure 1 is a perspective view of a preferred apparatus for generating hydrogen by photolysis of water using a titania electrode of the present invention, or various types of prior art photoactive electrodes.

Figure 2A is a schematic cross-section through the cylindrical core of the apparatus shown in Figure 1, the cross-section being taken in a plane including the axis of the cylindrical core.

Figure 2B is a schematic cross-section through the cylindrical core shown in Figure 2A, the cross-section being taken in a plane perpendicular to the axis of the cylindrical core.

Figure 2C is an enlarged cross-section taken in the same plane as Figure 2A and illustrates the electrodes of the core, and the apertured tube lying between these electrodes, with this tube having louvered apertures.

Figure 3A is a schematic cross-section similar to that of Figure 2A through an alternative cylindrical core which can be substituted for the core shown in Figure 2A.

Figure 3B is an enlarged cross-section, similar to that of Figure 2B, through the alternative core shown in Figure 3A showing the forms of the electrodes, which are substantially planar but are oppositely curved and are separated by a flat septum.

Figure 3C is a detailed view of one side faced of the flat septum shown in Figure 3B showing the grooves provided in the side faces of the septum.

Figure 4 is a schematic cross-section, similar to that of Figures 2B and 3B through a third core assembly, in which the electrodes are substantially planar but are together curved the same way with the septum so as to better form a seal with the inside of the tube.

Figure 5 is a schematic side elevation of a modified cylindrical core and associated apparatus for making use of excess heat generated within the core during operation and for reducing temperature gradients along the core axis.

Figure 6 is a schematic cross-section, taken perpendicular to the axis of the cylindrical core, through the reflector and core of the apparatus shown in Figures 1-4 to show the location of a photovoltaic strip.

Figure 7 is a schematic cross-section along the line 7-7 in Figure 6, with part of the reflector omitted for clarity.

Figure 8 is a schematic cross-section, similar to that of Figure 6, through a second modified form of the apparatus shown in Figure 1; in this second modified form, the core is disposed within the reflector.

Figure 9 is an enlarged cross-section through the photoactive electrode of the apparatus shown in Figure 8, in which the optical integrating cylinder feature is seen in more detail.

Figure 10 is a perspective view of a multiple core photolysis apparatus, optimized for vertical installation against a building wall or for use with heliostats.

Figure 11 is a perspective view of a second multiple core photolysis apparatus suitable for mounting on the roof of a commercial or residential building.

Figure 12 is a block diagram showing various auxiliary apparatus used in conjunction with the apparatus shown in Figure 1.

Figures 13A to 13C are schematic cross-sections through three stressed titania films of the invention and the underlying substrate, showing the stress in the coated titania layer.

Figure 14 is a graph showing the variation of the bandgap of anatase with applied pressure as calculated in the theoretical modeling described below.

Figure 15 is a graph showing the variation of efficiency of an anatase electrode with applied pressure resulting from the bandgap variation shown in Figure 14.

Figure 16A shows a full band structure plot for the anatase structure, while Figure 16B shows an enlarged view of the portion of Figure 16A indicated by the arrow therein and containing only the top of the valence band and the bottom of the conduction band, together with the quadratic fits used to calculate the effective mass of the charge carriers.

Figure 17 is a graph showing the variation of the effective mass of the electrons and holes in anatase with pressure, as calculated from quadratic fits similar to those shown in Figure 16A.

Figure 18 is a graph showing the variation of the effective mass of the electrons and holes in anatase with lattice constant, as calculated from quadratic fits similar to those shown in Figure 16A.

Figure 19 shows an embossing and vacuum coating process for forming the nano-structures and the titania, from the aforementioned Application Serial No. 10/424,259 .

Figures 20A and 20B are schematic side elevations showing nano-structures formed on a preformed substrate (Figure 20A) and by acid etching of a titanium metal film (Figure 20B).

Figure 20C is a scanning electron micrograph showing a section through titania coated on to a nano-hemispherical polycarbonate embossed template by the embossing and coating process shown in Figure 19.

Figures 21A to 21D shows strain calculations and thermal oxide titania growth modeling obtained with FLOOPS.

Figure 22 is a bar graph comparing the performances of titania photocatalysts prepared using various different etchants in the etching step.

Figures 23A and 23B are scanning electron micrographs of nanostructures obtained in the process of the present invention.

Figures 24A and 24B are scanning electron micrographs of nanostructures obtained in the process of the present invention but using a different etching medium from that used to prepare the nanostructures shown in Figures 23A-23C.

Figure 25 shows current-voltage curves for the experimental samples graphed in Figure 22.

Figure 26A is a graph showing the change in absorption over the range of 250 to 900 nm with anodizing at varying voltages of a titanium film.

Figure 26B is a graph similar to that of Figure 26B but showing the change in absorption at varying anodizing temperatures.

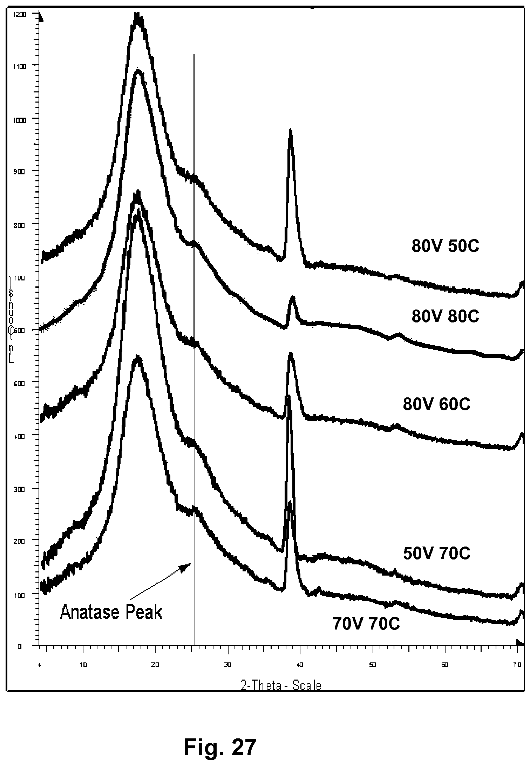

] Figure 27 is a graph showing the growth of the anatase peak with varying combinations of anodizing voltage and temperature.

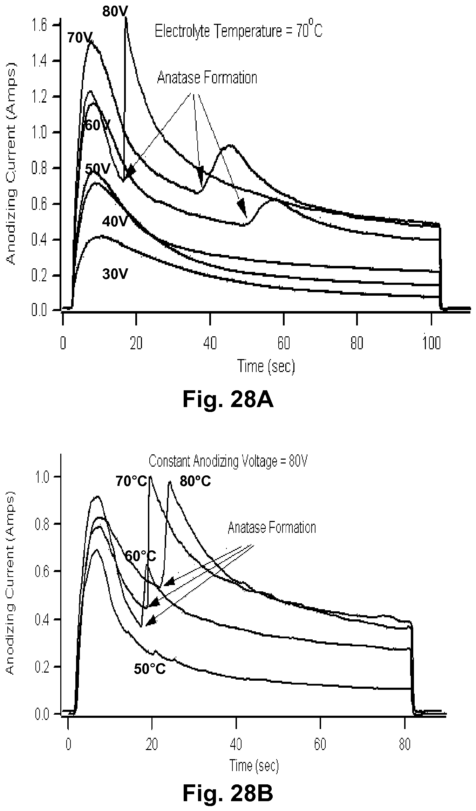

Figure 28A is a graph showing the onset of anatase formation at varying voltages of a titanium film.

Figure 28B is a graph similar to that of Figure 28A but showing the onset of anatase formation at varying anodizing temperatures.

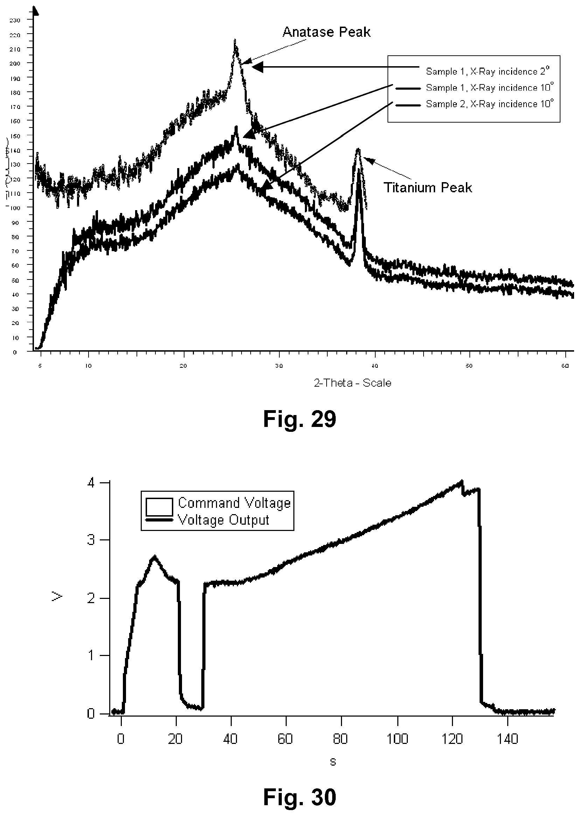

Figure 29 shows X-ray diffraction patterns for three different anodized titanium film and illustrates the presence of anatase in all three films.

Figure 30 shows the command voltage and the actual voltage output achieved during an anodizing process of the invention using the preferred voltage control apparatus and power supply described below.

Figure 31 is a three-dimensional graph showing the variation of photocurrent obtained from titania electrodes of the present invention as a function of the time and temperature of the thermal oxidation step of the process used to prepare the titania electrodes.

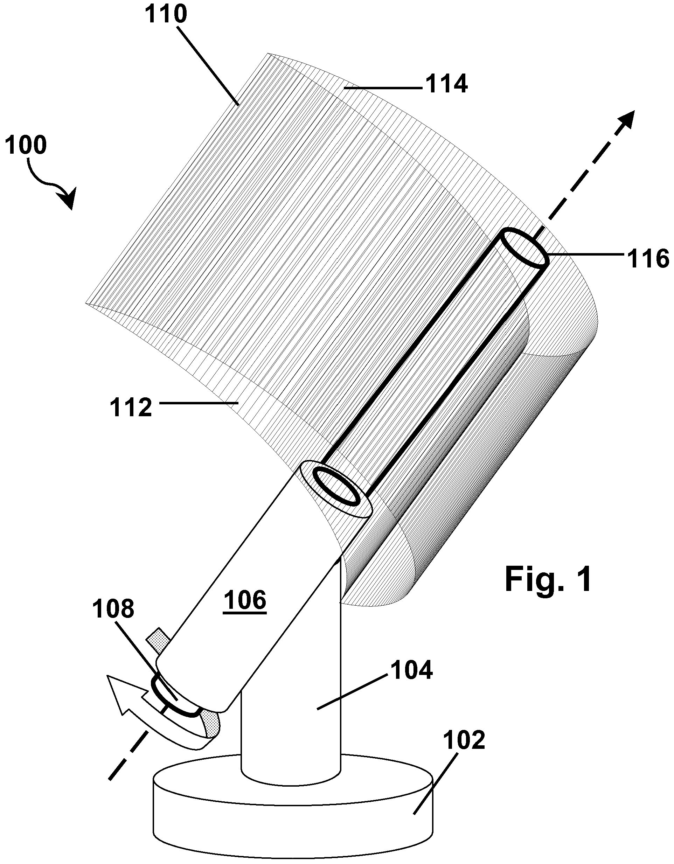

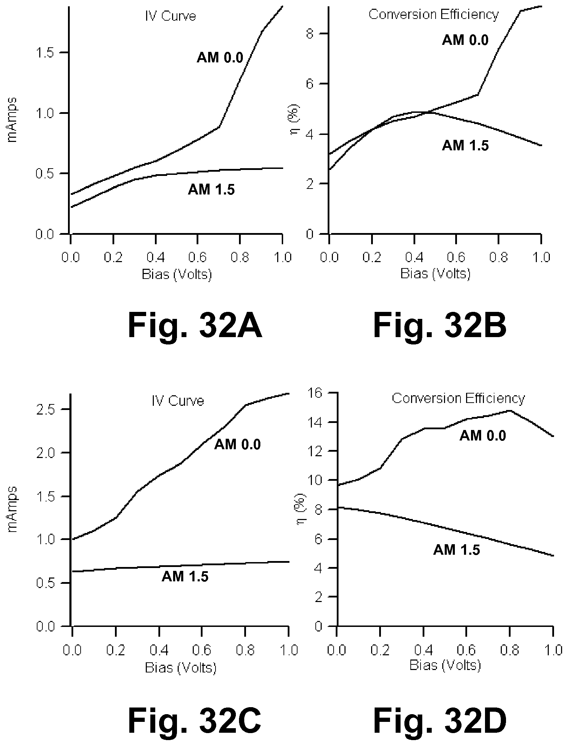

Figures 32A to 32D are graphs showing the rate of hydrogen generation of solar conversion efficiency of an apparatus as shown in Figures 1, 2 and 7 under varying conditions of temperature, illumination and bias voltage.

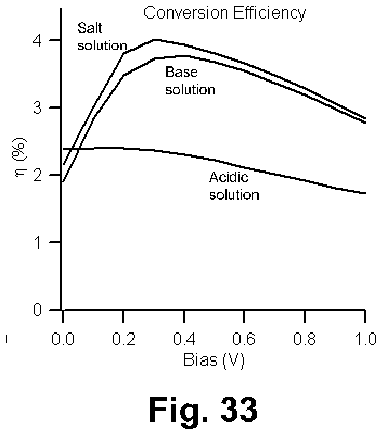

Figure 33 is a graph showing the conversion efficiency of an apparatus as shown in Figures 1, 2 and 7 under varying bias voltage supplied by the photovoltaic strip therein, as a function of electrolyte recipe.

Figure 1 of the accompanying drawings illustrates a first photolysis apparatus (generally designated 100) using a titania electrode of the present invention (although other known photoactive electrodes can also be used) for the production of hydrogen and oxygen from water. The apparatus 100 comprises a squat cylindrical base 102; when the apparatus is installed in a fixed location, this base 102 may be installed directly on the ground or, for example, on a concrete pad, which may be equipped with power lines for driving the apparatus 100 as described below. Alternatively, if it is desired to make the apparatus 100 mobile, the base 102 may be mounted on a wheeled platform (not shown) which may be equipped with jacks or chocks (also not shown) for holding the wheeled platform stable at any desired location.

A cylindrical support member 104 extends vertically upwardly from the base 102, and a polar housing 106 runs across the upper end of support member 104, the housing 106 being inclined so that its axis is parallel to that of the earth at the location where the apparatus 100 is being used. For simplicity, the housing 106 is shown as fixed relative to the support member 104. However, since the optimum angle of inclination of the housing 106 to the support member 104 will vary with the latitude at which the apparatus 100 is to be used, in the case of a mobile apparatus 100 it may be desirable to provide means for varying the inclination of the housing 106 to the support member 104.

The polar housing 106 has the form of a hollow cylinder, and a polar shaft 108 is rotatably mounted with the housing 106 by means of radial bearings (not shown), so that the shaft 108 can rotate about the axis of the housing 106, as indicated by the arrow in Figure 1. Rotation of the shaft 108 relative to the housing 106 is effected by a electric motor (not shown) located within the support member 104. A reflector assembly 110 provided with end caps 112, 114 and core assembly 116 are mounted via thrust bearings (not shown) on the shaft 108, so that by rotating the shaft 108, which is pointed at the North star and thus extends parallel to the axis of the earth, the reflector can follow the motion of the sun during the day. The reflector assembly 110 concentrates solar radiation on the core assembly 116 in a manner well known to those skilled in solar technology.

The single-axis mount shown in Figure 1 is the presently preferred mount; adjustments for the seasonal variation in solar elevation can be made by using an oversized photocatalyst, which can accommodate changes in focus with the seasons, within the core assembly 116, as described in detail below. A two-axis mount can alternatively be used to allow direct adjustment of the position of the reflector assembly 110 to allow for seasonal variation in solar elevation.

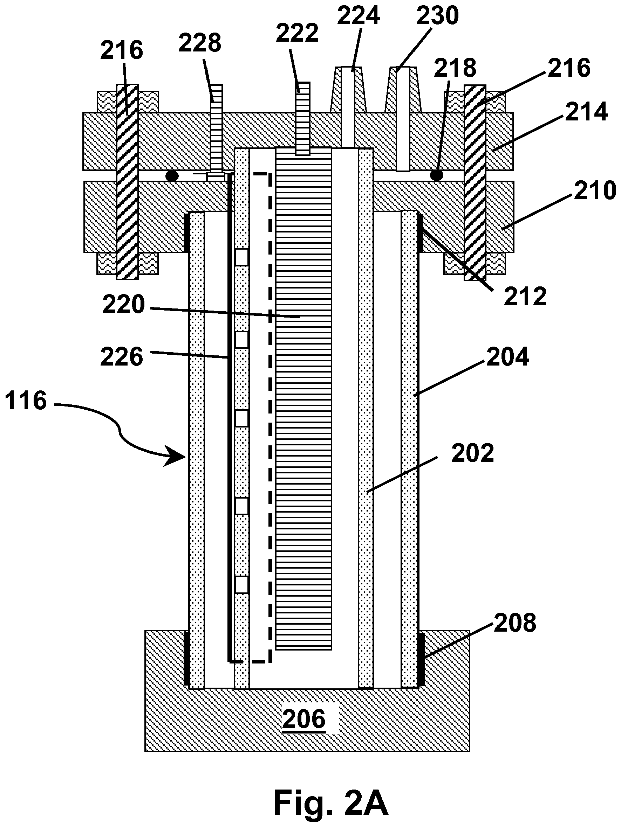

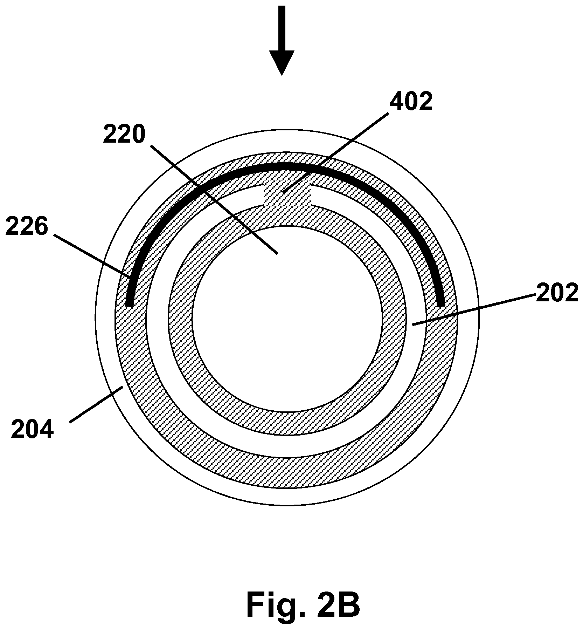

The core assembly 116 will now be described in more detail with reference to Figures 2A and 2B. As most easily seen in Figure 2A, the core assembly 116 comprises inner and outer hollow concentric tubes 202 and 204 respectively, which are formed of borosilicate glass, and polycarbonate respectively, although quartz or ultraviolet-transmissive acrylic polymer could alternatively be used for the outer tube 204, and other materials including PTFE (polytetrafluoroethylene, also known by the Registered Trade Mark Teflon) and FEP (fluorinated ethylene propylene) can be used for the inner tube 202 if the desired operating temperature and pressure are higher than can be tolerated by the polycarbonate. Materials may also be combined, for example by adding a heat-shrink tubular FEP jacket (McMaster Carr No. 8703K63) over all or some of the length of the polycarbonate tube. The lower ends of the tubes 202 and 204 are received within a cylindrical recess in a lower endcap 206, formed of polycarbonate or polyvinyl chloride; an annular seal 208, formed by injecting silicone rubber around the tube 204, extends around the outer tube 204 within the recess in the endcap 206 to provide a liquid-tight seal around the tube 204. The upper end of outer tube 204 is received within a cylindrical central aperture in a flange member 210, and an annular seal 212, similar to the seal 208, provides a liquid-tight seal around the tube 204.

The upper end of inner tube 202 extends beyond the upper end of outer tube 204 and is solvent welded within shallow cylindrical recess in a top plate 214, which lies parallel to and adjacent flange member 210. The top plate 214 is secured to flange member 210 by multiple bolts 216, only two of which are visible in Figure 2A. An O-ring (Viton) 218 is disposed between top plate 214 and flange member 210 radially outwardly of the upper end of outer tube 204. The top plate and flange member are machined or molded in polycarbonate, or can also be machined or molded in a higher temperature plastic such as ULTEM (Registered Trade Mark, a polyether imide made by G. E. Plastics.

The core assembly 116 further comprises a counter electrode 220 provided with a contact 222, in the form of a titanium screw, which extends through the center of the top plate 214 to provide a negative terminal for the core assembly 116. The counter electrode 220 is cylindrical and extends along the axis of the inner tube 202. The counter electrode 220 is formed of carbon or graphite, although any material which is inert to the hydrogen generated at this electrode when the apparatus 100 is operating may be used, for example reticulated glassy carbon, or stainless steel, such as stainless steel 316; obviously, it is desirable to keep the counter electrode 220 as simple and inexpensive as possible. However, it may be desirable to roughen or otherwise increase the surface area of this electrode to improve the efficiency of the apparatus 100. A hydrogen tube 224 extends from the upper end of inner tube 202 through the top plate 214 to provide a route for the hydrogen generated at the counter electrode 220 to leave the core assembly 116.

The second electrode of the core assembly 116 is a bandgap-shifted titania coated electrode 226 of the present invention, although as noted above other photoactive electrodes can be substituted. As best seen in Figure 2B, the titania coated electrode 226 has the form of a thin titanium sheet curved into substantially the form of an arc of a hollow cylinder, the curved sheet extending the full length of, and being wrapped around a portion of, the inner tube 202 so as to leave a small gap between the electrode and the inner tube (this gap is somewhat exaggerated in Figure 2B for ease of illustration). The electrode 226 is in electrical contact with a titanium screw 228 (Figure 2A), which is generally similar to the screw 222 previously described, extends through the top plate 214, and acts as the positive terminal for the core assembly 116. When the core assembly 116 is operating, oxygen is evolved at the electrode 226, and this oxygen passes through the chamber formed by the facing surfaces of the flange member 210 and the top plate 214 and the O-ring 218, and leaves the core assembly via an oxygen tube 230 similar to and extending parallel to the hydrogen tube 224 already described. The top plate 214 is also provided with an electrolyte supply tube (not shown) used for filling and refilling the core assembly 116 with electrolyte (described below). For reasons discussed below, the hydrogen and oxygen tubes 224 and 230 are provided with pressure relief valves (not shown) at locations further from the top plate 214 than is capable of being illustrated in Figure 2A.

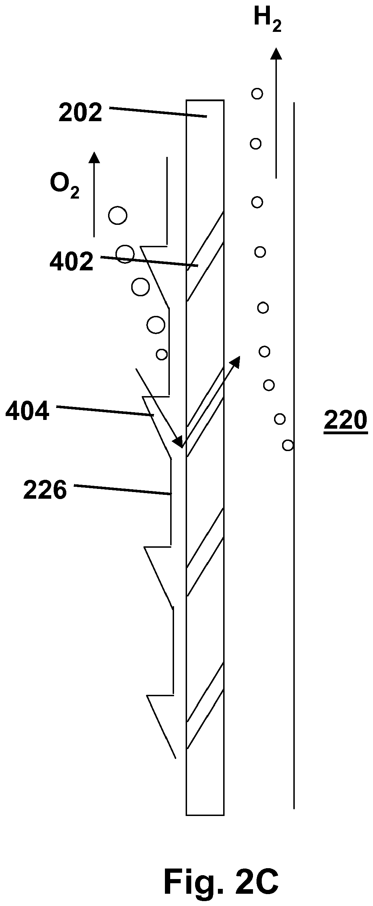

Figure 2B shows a cross-section perpendicular to the central axis of the core assembly 116 shown in Figure 2A, with the arrow indicating the face of the assembly which is intended to face the concentrated sunlight. The graphite counter electrode 220 has an outside diameter of 1 inch (25 mm) and a grain size of 0.03 to 0.00005 inch (0.75 to 0.00127 mm), with the preferred grain size being 0.008 inch (0.203 mm). One provider is NAC Carbon Products, Inc., Elk Run Ave., Punxsutawney, PA. The inner tube 202 has an internal diameter of 1.5 inch (38 mm) and an external diameter of 1.76 inch (45 mm). The outer tube 204 has an internal diameter of 2.76 inch (76 mm) and an external diameter of 3.0 inch (76 mm). The photoactive electrode 226 has a thickness of 0.010 inch (0.254 mm) and in practice fits somewhat more tightly around the inner tube 202 than is illustrated in Figure 2B. Apertures 402 (discussed in more detail below with reference to Figure 2C) passing through the inner tube 202 are 0.575 inch (15 mm) in diameter and disposed on 2 inch (51 mm) or less centers.

In operation, the tubes 202 and 204 are completely filled with an electrolyte solution capable of being photolyzed to hydrogen and oxygen. As shown in Figure 2C, to enable ions to flow between the electrodes 220 and 226, while keeping the hydrogen and oxygen evolved at these electrodes separate, the inner tube 202 is provided with a series of apertures 402 lying beneath the electrode 226, these apertures extending downwardly and radially outwardly, while the electrode 226 itself is provided with a series of vent louvers 404. As indicated by the diagonal arrows in Figure 2C, the combination of the louvers 404 and apertures 402 provides a short, large effective cross-section path for ion flow between the electrodes 226 and 220 through the inner tube 202, while keeping the evolved hydrogen and oxygen flowing separately upwardly, as indicated by the vertical arrows in Figure 2C, separated by the inner tube 202. For additional insurance that the hydrogen and oxygen are kept separate, the apertures 402 may be covered by a fluoropolymer membrane, such as that sold commercially by E. I. du Pont de Nemours & Co. under the Registered Trade Mark "NAFION". Such a membrane may be wrapped around the inner tube 202 and sealing, especially if hydrogen and oxygen pressures are equalized. Microporous materials such as ceramic or glass frits or a methacrylate (contact lens plastic) permeable to oxygen may alternatively be used, and such microporous materials can sustain substantial pressure differences between the two tubes. However, it has been found that satisfactory separation of gas can be achieved without providing such a membrane over the apertures.

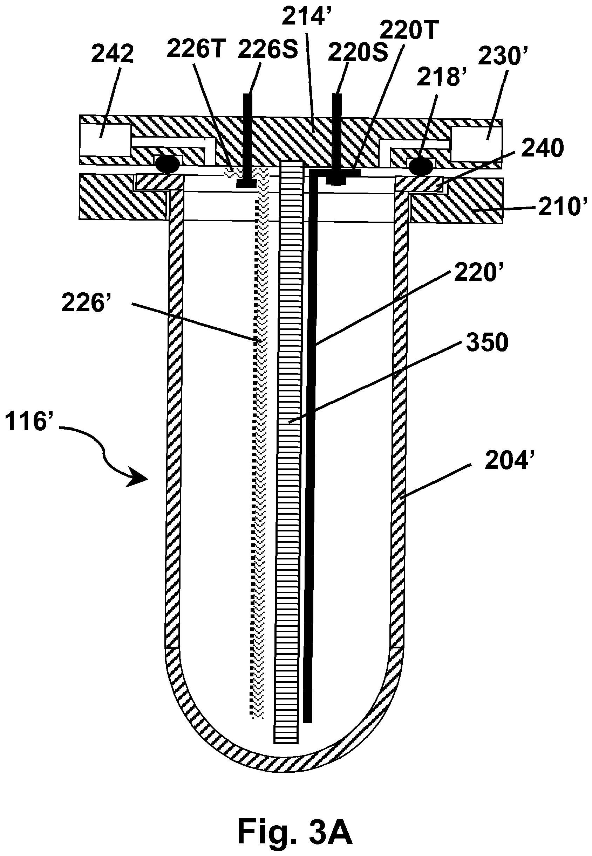

Figure 3A shows as modified version (generally designated 116') of the core assembly 116 shown in Figure 2A. In this modified version, the outer glass tube 204' has a rounded, sealed lower end and is provided at its upper end with an outwardly-extending flange 240, which is ground flat to accept an O-ring seal 218'. An annular backplate 210' with threaded holes is positioned below the flange 240, and an upper plate 214', having a groove which receives the O-ring seal 218' is bolted to the backplate 210' to form a seal. The upper plate 214' provided with an entrance port 242 for electrolyte and exit ports (only one exit port 230' is shown in Figure 3A) for gases generated.

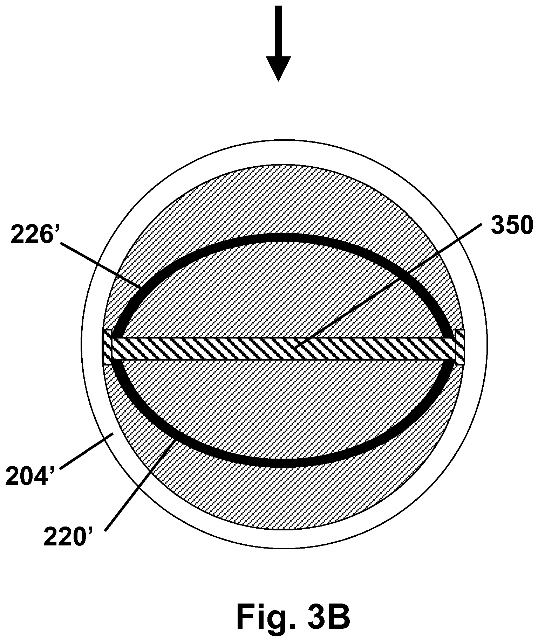

In the core assembly 116' of Figure 3A, the inner tube 202 present in the core assembly 116 shown in Figure 2A is eliminated, and instead a planar central septum 350, extends diametrically across the tube 204', effectively dividing this tube into two substantially hemi-cylindrical chambers, as most easily seen in Figure 3B. Note that the septum 350 does not make sealing contact with the lower end of the tube 204'. A titania/titanium electrode 226' and a counter-electrode 220' are mounted on opposed sides of the septum 350. (For ease of illustration, Figure 3A does not accurately represent the forms of these electrodes, which will be explained below with reference to Figure 3B.)

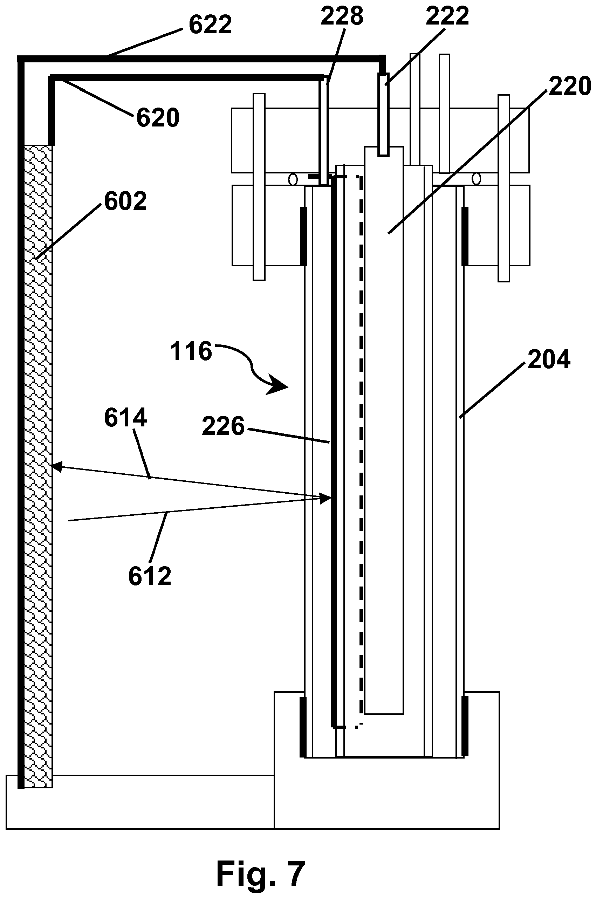

Each of the electrodes 220' and 226' is provided at its upper end with a tab (designated 220T and 226T respectively), each tab extending horizontally and thus perpendicular to the main part of the electrode. Titanium screws 220S and 226S respectively pass through the tables 220T and 226T respectively and the secure the electrodes 220' and 226' respectively to the upper plate 214'. To ensure proper sealing around the screws 220S and 226S, O-rings or other sealing means may be provided where the screws pass through the upper plate 214', but such conventional sealing means are omitted from Figure 3A for clarity. The upper ends of the screws 220S and 226S protrude above the upper surface of the plate 214' and are shaped and spaced to form a standard male plug size. This male plug may be connected via a female plug and cable to a photovoltaic strip (described below with reference to Figure 7) in order that the photovoltaic strip can provide a bias or over-voltage to the electrodes 220', 226'.

The planar septum 350 isolates the electrodes 220', 226' from each other to prevent a short circuit and also, as already noted, effectively divides the interior of the tube 204' into two substantially hemi-cylindrical chambers, with one electrode being present in each chamber. The upper end of the septum plate is received within a groove in, and sealed to the upper plate 214'. The necessary seal to the polycarbonate upper plate 214' may be formed by solvent welding, ultrasonic welding, heat welding, or a mechanical seal with or without silicone rubber adhesive sealant. The septum can be made of polycarbonate, polytetrafluoroethylene, silicone rubber, silicone rubber foam (closed or open cell) or other high temperature and inert material or plastic or combinations thereof, such as a polycarbonate septum with a sealing edge comprising silicone rubber tube that is split along its length and applied to the polycarbonate edges, or silicone rubber foam. The septum can also be polyester non-woven felt.

As shown in Figure 3B, the electrodes 220', 226' have substantially the form of parts of thin, hollow cylinders, with the vertical edges of the electrodes in contact with the septum 350 but with the central portions of the electrodes spaced from the septum.

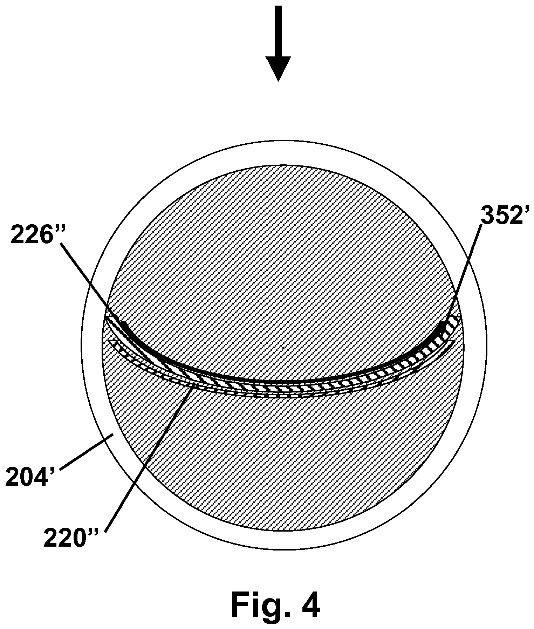

The counter electrode 220' shown in Figures 3A and 3B (and the similar counter electrode shown in Figure 4) will typically not be formed of the carbon, as is the counter electrode shown in Figures 2A-2C; instead the counter electrode 220' will typically be formed of a planar electrode material such as perforated stainless steel sheet, perforated low carbon steel sheet, perforated titanium sheet (platinized or not), TDA carbon strip or reticulated glass carbon. The TDA carbon strip is made from sheets that are reinforced with conducting carbon fiber and were obtained from TDA Research, 12345 W. 52$^{nd}$ Ave., Wheat Ridge, CO. The edges of the septum 350 make sealing contact with the inside wall of the tube 204' by press-fit. The photoactive electrode 226' and the counter-electrode 220' are formed into the illustrated arch shape by making the electrodes with a width slightly larger than the inside diameter of the tube 204'. However the electrodes can also lie adjacent to the septum surface and even be bonded to the septum for ease of replacement of the entire assembly comprising septum, both electrodes, and top plate 214'. The arches of the electrodes can be concave or convex as it faces the concentrating reflector, and the photoactive electrode can further include the apertures or louvers described earlier.

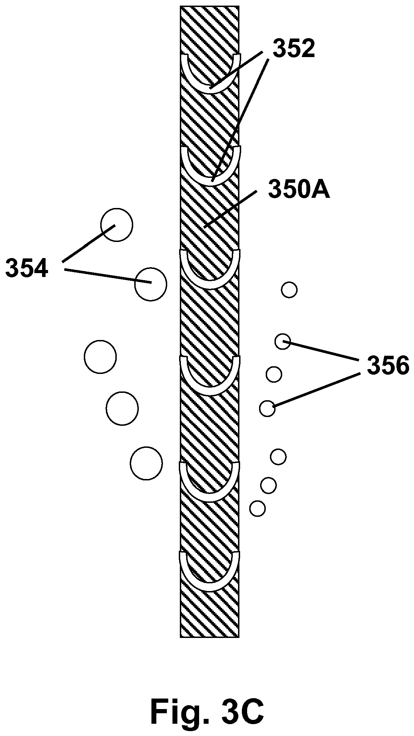

Obviously, it is necessary to provide for ionic conduction pathways between the electrodes 220' and 226'. However, unlike the inner tube 202 shown in Figure 2C, the main part of the septum is not provided with apertures. The ionic conduction pathway provided by the gap between the lower end of the septum 350 and the lower end of the tube 204' is not, by itself, adequate for this purpose. Accordingly, to provide additional ionic conduction pathways, the side faces (designated 350A in Figure 3C) of the septum 350 in contact with the inner wall of the tube 204',are interrupted periodically by slots or grooves 352 that are cut into the side faces 350A. The grooves 352 may be substantially semi-circular, as illustrated in Figure 3C, "V"-shaped or linear and cut at an angle, preferably of 45° or more. The grooves 352 create a short ionic conduction pathway, similar to that provided by the apertures 402 shown in Figure 2C, while preventing the oxygen and hydrogen gases (indicated schematically at 354 and 356 respectively in Figure 3C) from mixing due to buoyancy. Further, the grooves 352 can be alternating such that they impart a helical or screw effect to the flow of the electrolyte for enhanced convective flow.

Alternatively, if the septum 350 is formed of (for example) a silicone rubber open cell foam strip 0.25-0.5 inch (6 to 13 mm) thick, or a non-woven polyester felt, the grooves 352 are not needed to create ionic conduction pathways since the open cell structure of the foam or the open texture of the felt allows ionic communication to occur without allowing mixing of the gaseous products when immersed in the electrolyte. In all cases the septum material must be capable of surviving temperatures of at least 100°C and electrolytic solutions containing salts, acids, or bases. All of the materials discussed herein meet these requirements. Where adhesive is used to bond the titanium to the septum, acrylic adhesive is used. The titanium/titania electrode 220' can also itself act as a septum, if edge guides are provided that effect a seal to the tube 202' except in the area of the grooves 352.

Figure 4 illustrates a radical cross-section, similar to that of Figure 3B, through a modified version of the apparatus of Figures 3A-3C in which the septum (designated 352') is a flexible strip that seals to the inside wall of the borosilicate glass tube 204' by intimate contact. The titania/titanium electrode 226" and the counter electrode 220" are of substantially the same arcuate form as the septum 352' and are laminated thereto. Angled grooves (not shown in Figure 4) providing ionic conduction pathways are again formed into the edges of the septum 352'. This embodiment allows for a lighter core assembly that can have higher aspect ratios (i.e., the length to diameter ratio of the core assembly can be much higher) which is preferred for roof-top mountings, where the reflectors can be smaller in width for overall lower profile height.

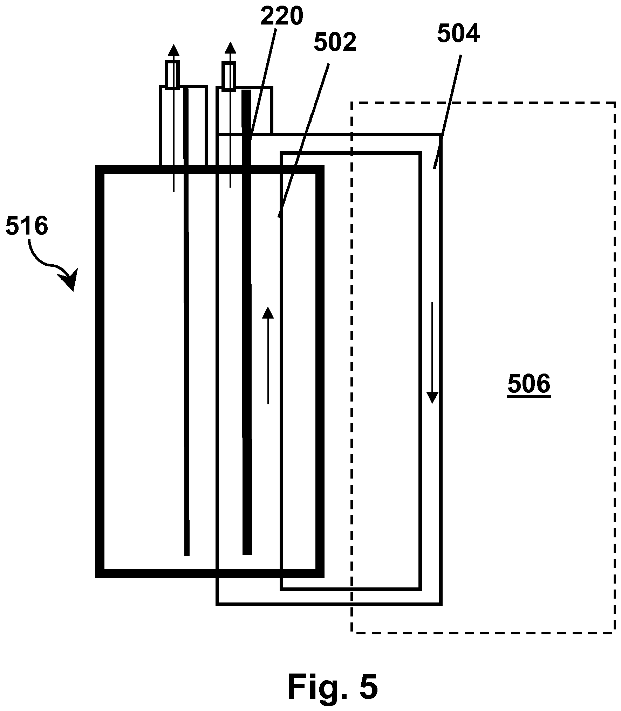

When any of the apparatus shown in Figures 1-4 is operating, there is a natural convective flow of electrolyte parallel to the axis of the core assembly. This convective flow can be used to cool the electrolyte in order to maintain a desired operating temperature and/or to remove from the core assembly heat which can usefully be employed elsewhere, for example in space heating, thus improving the overall efficiency of use of the radiation incident upon the apparatus 100. Figure 5 illustrates schematically a modified core assembly (generally designated 516) having the same central carbon anode 220 as previously described. However, the inner tube 502 of the modified core assembly 516 has a U-shaped external tube 504 joining its upper and lower ends. As indicated by the arrows in Figure 5, electrolyte circulates upwardly through the inner tube 502 and downwardly through the external tube 504, being cooled within the external tube 504 by a heat withdrawing apparatus indicated schematically at 506. The external tube 504 can be formed of Grade 2 titanium tubing for resistance to corrosion, for increased tolerance to heat, and for increased hydrogen pressure. By a further modification of the apparatus shown in Figure 5, the external tube 504 could be continuous with the titania electrode 226 (Figure 2) with the relevant portion of the titanium tube being treated to form a titanium photocatalyst of the present invention. This arrangement allows for reducing the temperature gradient along the photoactive portion of the titanium tube for more even operation along the length of this photoactive portion. Obviously, the core assemblies shown in Figures 3A-3C and 4 can also be modified as illustrated in Figure 5.

A closed convective loop is also present within the tube containing the carbon electrode and where the hydrogen is produced; this convection circulates the electrolyte in the "carbon" chamber past the interface with the "titania" chamber. As already noted, the interface between the two chambers can be a series of open holes, grooves, or a microporous material such as ceramic, fritted glass, or an ion exchange membrane such as fluoropolymer. This architecture enables higher differential pressures between the hydrogen and oxygen, in addition to increasing the rate of production and the production efficiency. The output is restricted by a ceramic frit to the pressure required, but keeps the aqueous electrolyte contained and circulating. Gas separation is achieved by common ports between the two electrolyte chambers that may be open holes, or the aforementioned microporous materials. The hydraulic pressure at the ports is substantially equal between the chambers so as not to damage the separation membrane, or if open holes are present, to avoid liquid flow across the holes.

Although not shown in Figure 1, the apparatus 100 also comprises a photovoltaic strip disposed along the axis of symmetry of the reflector assembly 110, and the apparatus is designed so that each of the core assembly 116 and the photovoltaic strip can make maximum use of the wavelengths of incident radiation which they are best equipped to use; as discussed in more detail below, the photolysis reaction carried out by the electrode 226 (Figure 2A) makes use of near ultraviolet and shorter wave visible (blue-green) wavelengths of radiation, whereas the photovoltaic strip makes use of wavelengths from about green in the visible range through red. For reasons explained below, in the preferred apparatus 100, it is important that the outer tube 204 (Figure 2A) transmit radiation of all the wavelengths used by both the electrode 226 and the photovoltaic strip, and this is one reason for forming the outer tube 204 of Type 3 borosilicate glass, which transmits radiation of all frequencies from infra-red to ultra-violet.

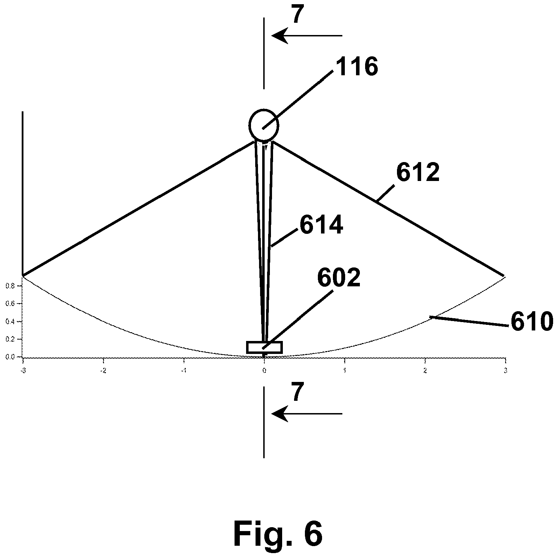

As may be seen from Figures 6 and 7, the photovoltaic strip 602 is disposed along the axis of symmetry of the reflector assembly 110 and is mounted on a mirrored elliptical reflector member 610 which reflects solar radiation. Solar radiation from the reflector member 610 travels, as indicated at 612, to the core assembly 116, where the ultraviolet and short wave visible radiation is absorbed, while the remaining radiation is again reflected and travels, as indicated at 614, to a secondary focus at the photovoltaic strip 602.

The reflection of the "unused" radiation (i.e., radiation not used by the titania electrode 226) from the core assembly 116 can be achieved in various ways, and one such way is illustrated schematically in Figure 7, where the radiation 612 from the reflector member 610 passes through the outer tube 204 (hence the need for this tube to transmit all the wavelengths used by both the electrode 226 and the photovoltaic strip 602) and strikes the electrode 226. The longer wavelength (green through red) radiation is reflected from the part-cylindrical electrode 602, passes back through the outer tube 204 is travels, as indicated at 614, to a secondary focus at the photovoltaic strip 602. Although, as described in more detail below, the electrode 226 has minor undulation or other surface roughness needed for its photovoltaic efficiency, its surface is still sufficiently smooth to reflect and focus most of the unabsorbed longer wavelength radiation used by the photovoltaic strip 602. For greater efficiency, the photovoltaic strip 602 may be covered by a coating which reflects the shorter wavelength radiation as well as the near-infra red used by the core assembly 116 to that core assembly.

Placing the photovoltaic strip 602 on an "outrigger" (the reflector member 610) to the core assembly 116, as shown in Figure 7, ensures that the strip 602 does not occlude reception by the titania photoelectrode 226 of any of the concentrated light from the collector, so that the strip 602 is in the shadow of the core, while being close enough to receive substantially all of the diffuse reflection of un-absorbed solar radiation from the core. In this way, the cost of a dichroic spectral separator is eliminated, and the titania electrode itself reflects unused parts of the spectrum to the photovoltaic strip, which is optimized for the unused solar spectrum parts. The core assembly 116 shown in Figure 7 may of course be the core assemblies shown in Figures 3A, 3B and 4. It should be noted that it may not always to advantageous to use highly efficient reflection or scattering of radiation to the photovoltaic strip. Large primary reflectors, such as that shown in Figure 1, can produce light intensities at the primary focus of the order of 30 suns (see below). Experimentally, it has been found that preferred titania electrodes produced in accordance with the present invention are capable of using light of this intensity without damage to the electrode. However, at present most photovoltaic strips cannot readily use this level of illumination and may be damaged or rendered less efficient thereby. Accordingly, in at least some cases where the design of the present apparatus produces very high light intensity at a photoreactor means located at the primary focus, it may be desirable to design the reflection or scattering system at the primary focus such that the intensity of illumination at the photovoltaic strip does not rise to a level which may damage the strip.

As already indicated, it is not essential that the back reflection of the radiation to the photovoltaic strip be effected by the electrode 226. Reflection or scattering may, for example, occur at the outer surface of the outer tube 204, by coating this surface with either a dichroic mirror or filter comprising a thin film optical stack (typically alternating layers of high refractive index and low refractive index metal oxide layers, such as titania and magnesium fluoride or silicon dioxide) coated directly onto the outer tube, or a holographic mirror. Obviously, whatever reflective or scattering coating is used on the outer tube 204 should be wavelength selective such that the wavelengths required by the electrode 226 pass into the core assembly 116 through the outer tube 204 and only the longer wavelengths needed by the photovoltaic strip 206 are back reflected on to this strip. Alternatively, the necessary wavelength selective reflector can be coated on to an additional tube surrounding the core assembly 116; the provision of such an additional tube may also be useful for preventing mechanical damage to the core assembly and/or protecting persons or apparatus near the core assembly 116 from injury should the pressurized core fail during operation.

As already indicated, the apparatus 100 uses a Dall-Kirkham reflective design, with an elliptical primary reflector, the reflector member 610, and a cylindrical secondary reflector, the electrode 226. In practice, this type of reflective design allows radiation concentration of about 30 suns without the need for precise optics, thus allowing a low cost, robust, light weight apparatus. Similar results can be achieved with a Cassegrain reflective design, with a parabolic primary reflector and a hyperbolic secondary reflector. The apparatus of the present invention may also may use of Newtonian (spherical primary and flat secondary reflectors, or a refractive concentrator, for example a Fresnel lens in preferably lenticular form that is manufactured from a UV-transparent material such as UVT (ultra violet transmitting) acrylic or borosilicate 3.3 glass.

As shown in Figure 7, the photovoltaic strip 602 is used to apply a bias voltage as well as over voltage across the electrodes 220 and 226. Bias voltage is required for the hydrogen production to proceed vigorously, while the over-voltage overcomes the various electro-chemical resistances in an electrolysis cell. For this purpose, opposed sides of the photovoltaic strip 602 are connected via conductors 620 and 622 to contacts 228 and 222 respectively and thence to the electrodes 226 and 220 respectively, with the positive conductor going to the electrode 226 and the negative conductor to the electrode 220. Under typical practical conditions, the photovoltaic strip 602 will apply a bias voltage plus over-voltage varying from about 0.5 V to 8 V (direct current) across the electrodes 220 and 226; as demonstrated below, it has been found that a bias voltage plus over-voltage of about 4V to 5.5 V provides optimum efficiency for solar assisted photolysis of water.

Obviously, a bias voltage and over-voltage can be applied to the electrodes 220 and 226 from a source other than a photovoltaic strip. Mains electricity can be used for non-solar electrolysis, or for solar-assisted electrolysis, after conversion of the high voltage AC mains electricity to low voltage direct current, which can then be supplied to the core assembly using the same conductors as for the photovoltaic strip. In this way, low cost over-capacity nighttime mains power can be used produce hydrogen; to generate hydrogen in the absence of illumination, the core assembly must be supplied with electricity at a voltage greater than the diode breakdown voltage of the core assembly, which is typically about 12 V. The mains electricity could, for example, be supplied by a wind farm (most wind farms produce the majority of their electricity at night), tidal generator or other generating apparatus the output of which varies with environmental conditions, thus providing a way to store the intermittent output from such a generating apparatus in the convenient form of hydrogen (with optional output of oxygen).

In the apparatus 100 described above, the core assembly 116 is disposed at the primary focus of the reflector assembly 110 and the photovoltaic strip 602 at the secondary focus. It will readily be apparent to those skilled in radiation collection systems that the locations of the core assembly and photovoltaic strip could be reversed. Moreover, placing the core assembly at the secondary focus allows (optional) mounting of the core assembly within the reflector assembly. An apparatus (generally designated 800) of this type will now be described with reference to Figures 8 and 9.

As shown in Figure 8, the apparatus 800 is of the Cassegrain type, with a parabolic main reflector assembly 802 and a hyperbolic secondary reflector 806, which is wavelength selective to reflect only shorter wavelengths and which overlies a photovoltaic strip 804. As indicated by the broken lines in Figure 8, incoming solar radiation is reflected from the main reflector assembly 802 as indicated at 812 and (if of appropriate wavelength) is further reflected from the secondary reflector 806 as indicated at 814 to a core assembly (generally designated 816) mounted within the reflector assembly 802. This arrangement allows the core assembly 816 to be placed close to or within the main reflector assembly for easier access and interconnection, and enables easier, lower energy solar tracking with very little need for counter-balancing; the core assembly can be co-axial with the rotation axis of the main reflector assembly.

Placing the core assembly at the secondary focus also allows for an advantageous modification of the form of this assembly. As schematically indicated in Figure 8, the core assembly 816 comprises a transparent outer tube 818 similar to outer tube 204 (Figure 2) of apparatus 100, but the internal arrangement of the core assembly 816 differs from that of the core assembly 116 of apparatus 100; in core assembly 816, there is no inner tube and the electrodes 820 and 826 extend parallel to but spaced from each other. As most easily seen in the enlarged view of Figure 9, the photoactive electrode 826 is formed as an "integrating cylinder", that is to say the photoactive electrode 826 is substantially cylindrical with the photoactive surface on the *inside,* and having a slit 828 running axially along to cylinder such that the tightly focused light 814 from the secondary reflector enters the cylinder and is able to undergo multiple reflections within the cylinder multiple times until substantially completely absorbed by the photoactive surface. This increases the efficiency of photon conversion by the electrode 826.

The apparatus 800 is well adapted for construction as an extruded or molded plastic ribbed reflector design, with all feature for mounting the core assembly 816 and other components molded in. The main reflector assembly can, for example, use a rear-surface ultra-violet reflecting layer on ultra-violet transmissive acrylic polymer, and be epoxy-overcoated. Acrylic polymers can be flexed into the parabolic or hyperbolic main reflector shape, as required, by pre-formed grooves of the desired shape in the aforementioned plastic ribs and provide a smooth optical surface which is durable against hail and other weather.

The main reflector assembly is typically one of two main types. In the first type, the end caps or end wings determine the shape of the mirror. The two end caps are connected to each other by a series of tubes, with one tube at each tip of the end caps, and one or more tubes in between. The end tubes are solvent cemented or otherwise secured connected to the end caps, and a tension rod can run down the center of the tube for added strength. Cross bracing between the tubes can be added for additional stiffness under wind loading. A slotted guide is attached to the facing inside surfaces of the end caps to define the shape of the main reflector. The main reflector material is inserted into the slotted guides. The main reflector material is made sufficiently flexible that it follows the shape determined by the guides faithfully, while also smoothing out any irregularities in the manufacture of the end caps or guides. The end caps are typically blow-molded of a recyclable high density polyethylene (HDPE) plastic, and the molding process allows for many features to be easily integrated into the end caps, including the guides, mounting flanges, stiffening ribs, product identification, and safety and other information. Alternatively, these end caps can be CNC (computer numerically controlled) routed from stock weather-resistant HDPE or other plastic sheet of about 0.75 inch thickness, such as Seaboard™ manufactured by Compression Polymers Corporation. The main reflector mounting material may, as already indicated, be ultra-violet resistant plastic, or may be powder coated or painted to resist ultra-violet degradation. The main reflector material can be an ultra-violet transmitting acrylic polymer such as poly(methyl methacrylate), known commercially as Plexiglas, with a mirror coating applied to its rear surface, this coating being optimized for reflection of ultra-violet as well as the visible and infra-red radiation. Another excellent UV transmitting PMMA is G-UVT manufactured by Arkema. Alternately, the main reflector material can be an acrylic or polycarbonate sheet about 1/8 inch (about 3.2 mm) thick with a layer of sheet metal reflector adhered to its front surface facing the sun. The metal reflector in this case can be an anodized polished aluminum product, for example MIRO produced by Alanod GmbH. This product is overcoated with silicon dioxide and then titanium dioxide for improved ultra-violet reflection, the titanium dioxide also provides self-cleaning properties and ruggedness, since the hydrophilic nature of titanium dioxide causes rain to remove accumulated dirt from the surface, thereby reducing maintenance and improving lifetime. The metal dents easily, so in case of hail, the main reflector assembly is inverted, so that the acrylic polymer absorbs and deflects shocks caused by impact of hail.

In the second type of reflector assembly, the assembly is a CNC routed form or molded form having the cross section seen in Figure 8, typically formed of a recycled plastic, and has edge receivers built in to receive either the mirror or the metal mirror sheet. For reflectors about 2 meters wide and 3 meters long, the acrylic backing mirror material should be about 1/8 inch to 3/16 inch (about 3.2 to 4.7 mm) thick, providing the optimum ratio of flexibility to stiffness for a smooth continuous optical curve.

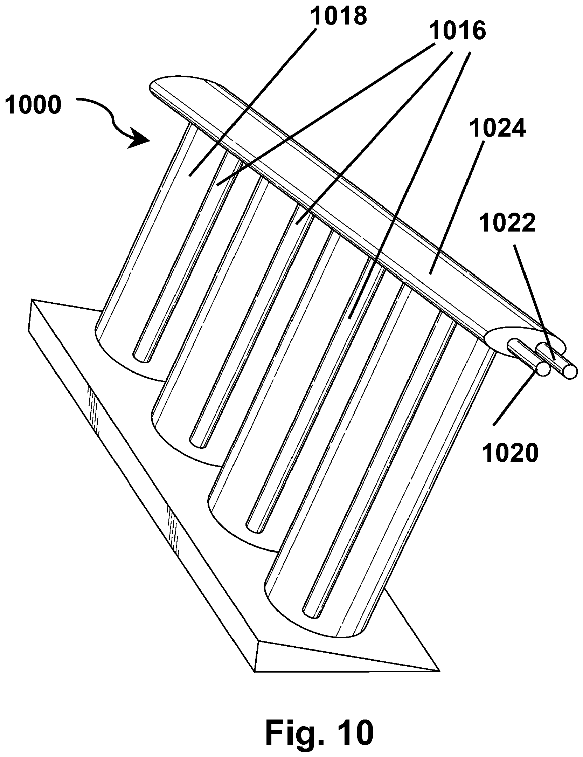

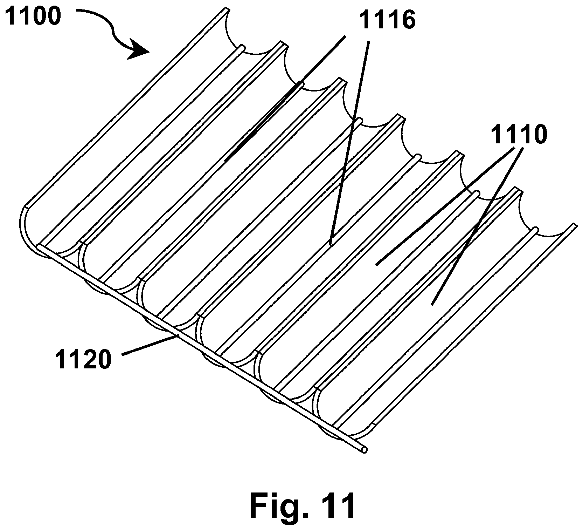

The apparatus 100 and 800 previously described are freestanding units provided with their own supporting members and intended to be disposed in open areas away from other structures. However, the apparatus of the present invention can also be designed to be mounted on a building wall or roof, and Figures 10 and 11 illustrate two different embodiments of this type.

The apparatus (generally designated 1000) shown in Figure 10 is of a "tower" type intended to be supported on a building wall. The apparatus 1000 comprises a plurality of elongate parallel core assemblies 1016, each similar to the core assembly 116 shown in Figures 2 and 7; for simplicity, Figures 10 and 11 do not show the internal components of their core assemblies. Each core assembly 1016 extends along the axis of an outer cylinder 1018, which is formed of an acrylic polymer capable of transmitting ultra-violet and visible radiation. Each outer cylinder 1018 is sealed at its lower end and its upper end is covered, and the cylinder is filled with water, so that is acts as a focusing lens concentrating sunlight on to the core assembly 1016 running along its axis. Advantageously, the water within the outer cylinders 1018 is mixed with sufficient glycerol to raise its refractive index from the 1.33 of pure water to match the 1.45 refractive index typical of acrylic polymers, thus improving the performance of the cylinder in concentrating solar radiation on the core assembly 1016. The glycerol also acts as an antifreeze to prevent damage to the apparatus 1000 if the apparatus is exposed to freezing temperatures. Alternatively, a Fresnel lens formed of an ultra-violet transmitting polymer can replace the fluid-filled cylinder 1018, and the use of such a Fresnel lens may be advantageous when the apparatus is to be mounted in a location (for example, on a roof which is not capable of supporting large loads per unit area) where the weight of the fluid-filled cylinders may be a problem. The outer cylinders 1018 also act as containment vessels should a core assembly fail during use, and thus allow operation of the core assemblies 1016 at higher pressures than would be safe if the outer cylinders were not present. Oxygen and hydrogen are removed from the apparatus 1000 via tubes 1020 and 1022 respectively, these tubes being housed within a protective manifold 1024.

In the apparatus 1000, it is advantageous for the photoactive electrode to occupy a greater proportion of the hollow cylinder than the less than hemicylindrical electrode 226 shown in Figure 2; using a photoactive electrode which occupies more than a hemicylinder allows good use of solar radiation without the need for solar tracking such as that carried out by the apparatus 100 described above. For the same reason, the apparatus 100 typically does not incorporate a photovoltaic strip, since if such a strip is included the apparatus 1000 needs to be modified to allow the photovoltaic strip to remain at the secondary focus of the optical system.

So far as possible consistent with the mounting location being used, the axes of the cylinders 1018 shown in Figure 10 should be tilted so as to parallel to the earth's axis, in the same way as the axis of the polar housing 106 of the apparatus 100 shown in Figure 1. The cylinders 1018 should also be spaced apart so that they do not shadow each other.

In a variant of the apparatus 1000 shown in Figure 10, the fluid-filled cylinders 1018 are modified by inserting a second sheet of ultra-violet transmitting polymer within each cylinder, this second sheet being solvent welded to the inside surface of the main cylinder 1018 so as to form a meniscus focusing lens, which is filled with an optical oil or glycerol having a refractive index close to that of the ultra-violet transmitting polymer. The external form of the cylinder 1018 is unchanged but the core assembly 1016 is moved from the axis of the cylinder 1018 to adjacent the back surface thereof (i.e., adjacent the surface on which the apparatus 1000 is mounted) where the new primary focus is located. A photovoltaic strip may be mounted in the center of the rearward surface of the meniscus focusing lens. This form of the apparatus does require solar tracking, but such tracking is readily achieved by mounting the cylinders 1018 on rollers which can be rotated by an appropriate motor.

The cylindrical tower apparatus 1000 shown in Figure 10 is more resistant to high winds than the apparatus 100 shown in Figure 1, and is more easily integrated into a building design. The apparatus 1000 may also be considered more architecturally attractive than the freestanding apparatus 100.

Figure 11 illustrates a further multi-core apparatus (generally designated 1100) of the present invention which is generally similar to the apparatus 1000 shown in Figure 10 but is adapted for roof mounting. The apparatus 1100 comprises a plurality of elongate parallel cores 1116 joined by a common manifold 1120; obviously, if desired, a second common manifold could be provided at the opposed ends of the cores 1116 from the manifold 1120. However, in the apparatus 1100, concentration of radiation is provided by a plurality of hemicylindrical, mirrored reflectors 1110; alternatively, a multiple Fresnel top sheet overlying the cores 1116 could be substituted for the reflectors 1110.

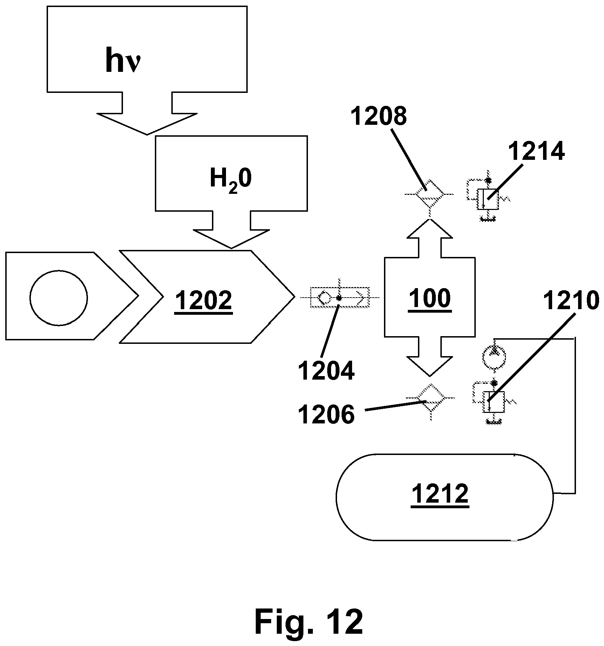

Figure 12 illustrates schematically the various auxiliary apparatus which is used in conjunction with the apparatus 100 described above to collect and store the hydrogen and oxygen gases produced and to refill the apparatus with water to replace that electrolyzed. Although not shown in Figure 2, the apparatus 100 is in fact provided with an additional tube extending through the top plate 214 through which additional way can be introduced into the apparatus, as schematically illustrated by "$H_2O$" in Figure 12. As already described, the apparatus 100 is also supplied with solar (or other) radiation, as schematically illustrated by "hv" in Figure 12. The additional water ("feedstock") can be ocean water. While the electrochemical potential for forming chlorine gas is very close to that of oxygen formation, it is still higher, so oxygen is formed preferentially over chlorine gas at low brine concentrations. Ocean water is only 3.5% sodium chloride by weight, which is a low concentration, and so chlorine is not formed. However, if ocean water is the sole replacement water, the salt concentration will grow within the apparatus 100 until it reaches saturation, or about 21% by weight, after which salt would precipitate out within the apparatus as sediment which have to be removed. However, because typically the formation of chlorine gas is not desired, the core assembly 116 (Figure 2) is flushed with ocean water at intervals (at least annually) to keep the salt concentration low. As indicated schematically at 1202 in Figure 12, the apparatus includes provisions for filtering incoming water to remove algae, rust, iron, chlorine, fluoride, and other contaminants. After filtration, the water passes through a float valve system 1204 during cool, low pressure condition of the core assembly 116 at night or at other times of low pressure within the core assembly.

As schematically indicated in Figure 12, the hydrogen and oxygen gases leaving the apparatus 100 pass through pressure relief valves, 1206 and 1208 respectively, that provide both backpressure with the core assembly 116 and safety pressure release. The hydrogen then passes through compression apparatus 1210 and is stored under pressure in a tank 1212; the oxygen may be similarly compressed as indicated at 1214 and stored (storage tank not shown), or, depending upon the location of the apparatus 100 and commercial demand, may simply be vented to atmosphere. Those skilled in the art of gas collection will understand that a variety of additional apparatus may be included which is not shown in Figure 12, for example thermal probes to monitor electrolyte temperatures, condensers and desiccants to conserve electrolyte and remove water vapor from the output gases, and analytical equipment to ascertain the purity of the output gases prior to compression and storage.

In this connection, it should be noted that, in the multiple core apparatus of Figures 10 and 11, the pipeline connections to individual core assemblies are arranged in parallel rather than serially, so that a leak in one core assembly only affects the leaking core assembly and not the entire apparatus.

Although the apparatus has been described above principally as used to generate hydrogen and oxygen from water, the chemistry of the electrolyte can be altered to produce different electrolysis products that may be useful for manufacturing processes. For example, if the electrolyte is a brine with high salt concentration, the products will be hydrogen gas, chlorine gas, chlorine water (water containing dissolved chlorine gas and/or other chlorine compounds) and sodium hypochlorite, a bleach. If sodium carbonate or bicarbonate are used, the gaseous products are hydrogen and carbon dioxide. Additionally, if carbon dioxide bearing electrolytes are used, such as carbolic acid and/or carbonated electrolyte, the product can be carbon monoxide. In this way, carbon dioxide from fossil fuel plants or other production can be sequestered in an electrolyte and then converted with sunlight to carbon monoxide. The carbon monoxide is then used as the feedstock to produce methane or even gasoline-like liquid fuels by adding hydrogen, as is well known. Such processes are Fischer Tropsch or variants of them. But in this case the carbon monoxide and the hydrogen are produced with sunlight and a photolytic reaction, and may even be combined in the same core. A liquid fuel produced in this way is carbon neutral, in that it sequesters as much carbon as it releases upon being combusted. Further, the infrastructure for handling, transporting, and using liquid fuels already exists.

As already mentioned the preferred forms of the apparatus can use any photoactive electrode capable of photolysis of water to hydrogen and oxygen, or of the other photolytic reactions discussed in the preceding paragraph. However, this invention also provides preferred photoactive electrodes for use in the apparatus described above or similar apparatus; more specifically, this invention provides photoactive electrodes containing bandgap shifted titania and a process for the production of such photoactive electrodes; in this process, an acid etch of a titanium film (which can be a film of the relatively impure and inexpensive Grade 1 or Grade 2 titanium) is followed by conversion of the etched titanium film to titania by anodization or heat oxidation.

It is known that the bandgap of a semiconductor can be altered by (1) doping, (2) adding stress, and (3) adding heat. The present invention makes use of the stress that is inherent in thin films, and specifically the tensile stress, to shift the bandgap of a semiconductor further into the visible spectrum. Bandgap-shift from local heating caused by self-focusing of radiation within the film also contributes to the bandgap-shift effect, but appears to be of secondary importance in this invention. For example, the energy bandgap of gallium arsenide (GaAs) requires a 900°C change in temperature to drop only 0.4 eV, from 1.5 eV at 100°C down to 1.1 eV at 1000°C. On the other hand, significantly higher magnitude changes in stress can be achieved in this invention, and hence stress is the predominant factor in the lowering of the bandgap energy.

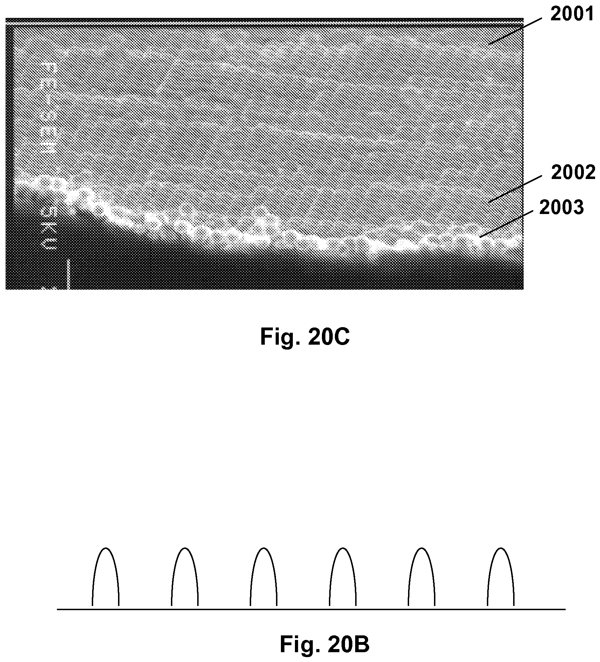

When tensile stress is applied to or caused in a semiconductor, the inter-atomic spacing increases directly. An increased inter-atomic spacing decreases the potential seen by the electrons in the material, which in turn reduces the size of the bandgap. The same effect occurs with increased temperature, because the amplitude of the atomic vibrations increases with increased thermal energy, thereby causing increased inter-atomic spacing. In the present invention, accordingly, stress is carefully controlled to achieve the desired bandgap shift. The stressed titania film used in the apparatus of the present invention may or may not be formed on substrate separate from the titanium/titania layer itself. If the titania (or similar) film is formed on a substrate, the stress is further managed to prevent delamination, by introducing periodic three-dimensional nano-scale surface features into or on to the substrate. These features act as a template such that the film that is grown on to the template takes on a similar shape. Figure 20B is a schematic side elevation of a titania film grown on to a polycarbonate template comprising a close-packed three dimensional sinusoidal surface, much like an egg carton, with a spatial period of 300 nanometers (nm) or 0.3 microns. The resulting titania features or nanostructures are adjacent hemi-cylinders, at the apex of which the titania is in very high tensile stress (otherwise known as strain). It should be noted that there are essentially no gaps between adjacent nanostructures.

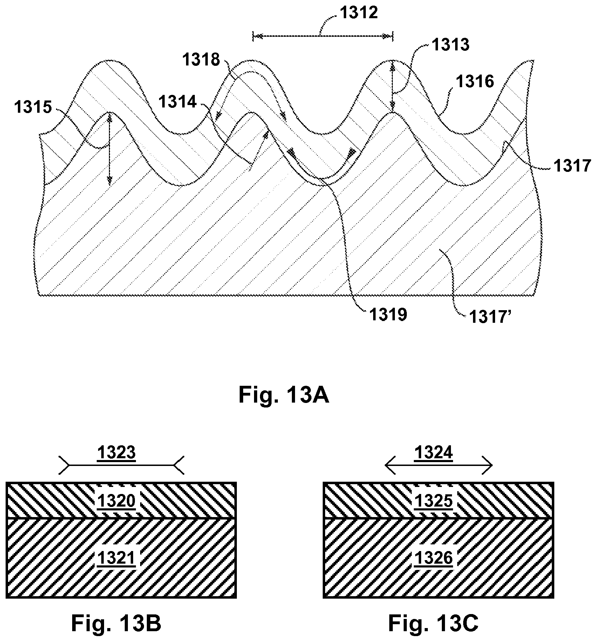

Figure 13A is a cross-section showing a substrate 1317' having undulations 1317 on its surface that transfer to a titania coating 1316 applied by a vacuum technique as taught in the aforementioned U.S. Patent No. 7,485,799. The titania coating has a film thickness 1313 of about 200 nm, although it can be thinner or thicker depending on the coating conditions and the geometry of the substrate. As shown in Figure 13A, the titania coating undulations can be made conformal, i.e. they can follow the curves in the substrate exactly, but they can also be made non-conformal, more like adjacent hemi-cylinders, with sharp cusps in between, depending on the coating film growth conditions and target to sample geometry, and the substrate undulation geometry: peak to valley height 1315, radius of curvature 1314, and pitch 1312. With a polycarbonate substrate 1317', the thermal contraction of the polycarbonate after coating is larger than of the titania thin film, resulting in very high stresses in the titania layer, namely tensile stress (indicated at 1318) at the apices of the undulations, and compressive stress (indicated at 1319) in the troughs. Such compressive and tensile stresses are present in thin film coatings on planar substrates as well, depending on whether the substrate grows or shrinks, respectively, relative to the film after coating, and such surfaces are within the scope of this invention when applied to stress-induced bandgap shifting, particularly of titania.

Figure 13B is a cross-section through such a planar substrate 1321 and titania coating 1320, in which the stress (indicated at 1323) is compressive, while Figure 13C is a similar cross-section through a planar substrate 1326 and planar coating 1325 in which the stress (indicated at 1324) is tensile stress. The undulations in the preferred embodiments create much higher tensile stresses because of the introduction of very small localized bending radii, such as the radius 1314 in Figure 13A. In addition, in some embodiments of the invention the undulations provide a mechanical lock between the substrate and the coating, which allows high stresses to exist without delamination.

The resulting bandgap-shifted semiconductor, titania in the preferred embodiment, is then applied to photoelectrolysis for hydrogen production, or for photovoltaic electricity production, or photocatalysis for detoxification and disinfection, as described below. Other semiconductors, including but not limited to strontium titanate, amorphous silicon, hydrogenated amorphous silicon, nitrogenated amorphous silicon, polycrystalline silicon, and germanium, and combinations thereof, will also exhibit a shift in their respective band-gaps toward a more favorable part of the solar spectrum with this applied stress.

As described above with reference to Figure 13A, titania at the apex of a sinusoidal surface experiences tensile stress, while the titania in the trough of the sinusoidal surface experiences compressive stress. Thus, in photoelectrolysis, detoxification, and disinfection, the desired photocatalytic activity is induced in the titania at the part of the surface (apex) closest to the object of photocatalysis. Because the stress varies continuously from tensile to compressive, the bandgap is not only shifted but broadened as well. Further, more of the film is in a beneficially stressed state than would be the case for a bulk form of the titania, where the stress would be largely near the surface and a comparatively much smaller percentage of the bulk volume of the semiconductor.

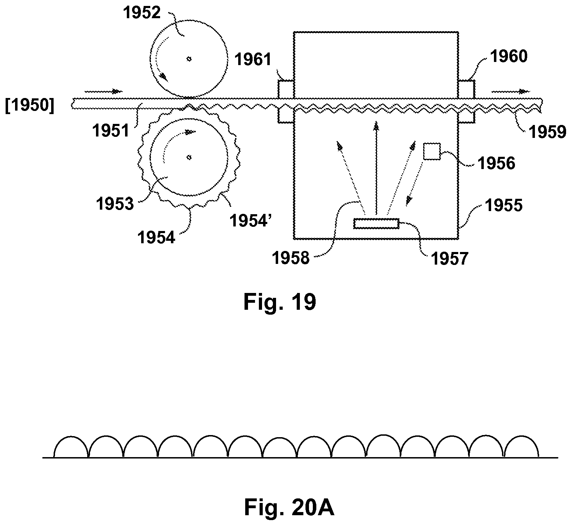

Figure 19 illustrates schematically one method for large scale manufacture of photoactive electrodes of the present invention comprising titania films on undulating substrates. In Figure 19, a polycarbonate substrate or a titanium foil (also known as a coil in the industry) 1951 is delivered from a roll (indicated at 1950) into an embossing machine, in which a stamper 1954 containing the desired undulation shape and pattern 1954' and wrapped around roller 1953, is embossed into the polycarbonate or the titanium coil using known embossing techniques that may include heat and/or solvents to varying degrees. The stamper is typically a nickel replica grown from a master, and may be coated with a harder material such as diamond-like carbon coating when working with titanium coil. The master is typically a photoresist or photoablative polymer on a glass or silicon substrate, into which the desired undulations have been formed by one of the following methods: contact lithography, projection lithography, interferometric lithography, or laser beam recording. Finally, the embossed polycarbonate web is coated in a vacuum chamber 1955 with e-beam 1956 (the preferred method, although others can of course be used) sputtering, ion-assisted deposition, or thermal evaporation, from a target 1957. Material 1958 from the target then deposits onto the web 1951. The result is that the polycarbonate or titanium emerges from the chamber coated with, in this example, titania 1959. In Figure 19, sealing means 1960 and 1961 are provided to maintain a vacuum lock on the web, but the entire roll can alternatively be in the coater at one time. Sol gel or chemical vapor deposition are also possible means of coating. Also, instead of roll manufacture, the polycarbonate substrates can be injection/compression molded to the stamper. All of these techniques are known in the optical data storage and other industries. It is an important advantage of the present invention that bandgap-shifted titania can be manufactured with existing infrastructure in low-cost mass production methods, because any solar energy conversion application requires large area, low cost devices. However, in the case where the base material is titanium foil, it will be seen that it is advantageous to use a titania forming method other than vacuum coating.

However, as already mentioned, the preferred method for producing stressed titania films comprises etching of titanium metal to form nano-structures in the titanium, followed by anodizing or oxidation, or both, to convert the etched titanium to titania, preferably in the anatase form. As a preliminary matter, some theoretical discussion of the variation of titania bandgap with physical parameters will be given; this theoretical discussion is of course also applicable to nano-structured titania coatings produced by the first method of the present invention.

As already mentioned, it is well known that the bandgap of a semiconductor changes with change in volume of its lattice, this change of volume being caused by, *inter alia*, temperature change or applied pressure. To understand how this general principle applied to the anatase form of titania, changes in the bandgap of this material were modeled as a function of biaxial strain. To achieve quantitatively accurate results, the GW approximation was used to calculate the bandgap. The GW approximation (GWA) is an approximation made in order to calculate the self-energy of a many-body system. The approximation is that the expansion of the self-energy $\Sigma$ in terms of the single particle Green function G and the screened interaction W can be truncated after the first term. We used ABINIT software to achieve the GW approximation (ABINIT is a free software package for physicists, distributed under the GNU General Public License, whose main program allows the total energy, charge density, and electronic structure of systems made of electrons and nuclei (molecules and periodic/crystalline solids) to be calculated within Density Functional Theory (DFT), using pseudopotentials, and a plane wave basis.)

It was also important to determine the effective mass of the charge carriers in the semiconductor, since large effective mass charge carriers can lead to higher recombination of photogenerated electron-hole pairs and hence to reduce efficiency of the electrode. Accordingly, density functional theory modeling was used to produce complete band structure plots which could be used to estimate the effective mass of the charge carriers. Theoretically, the bands follow a quadratic relationship around the conduction band minimum and valance band maximum energies. The curvature of this quadratic is inversely proportional to the effective mass. Integrating ASTM International (originally known as American Society for Testing and Materials) solar irradiance data and assuming 100% photon conversion efficiency leads to the maximum achievable solar-to-hydrogen conversion efficiency. Using the GW modeling result from above further allows us to model this maximum efficiency as a function of total pressure. The band gap of anatase at zero pressure was assumed to be 3.2 eV, corresponding to a maximum efficiency of about 3.7%.

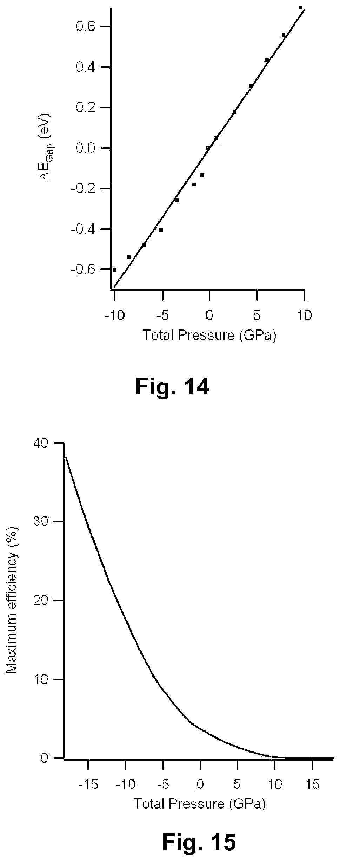

Figure 14 shows the change in bandgap $\Delta E_{Gap}$ with pressure derived from the GW approximation. The calculation indicates that the bandgap is expected to change linearly as a function of the applied pressure at a rate of 0.0686 eV/GPa. Thus, a pressure of about -10 GPa (a negative pressure denoting a material in tension) reduces the bandgap of anatase from 3.2 to about 2.5 eV. Figure 15 shows the expected increase in photolytic efficiency resulting from the bandgap reductions with pressure shown in Figure 14; it will be seen from Figure 15 that negative pressure of about -10 GPa is expected to increase the efficiency of the electrode about five-fold, from about 3.7 per cent to about 20 per cent.

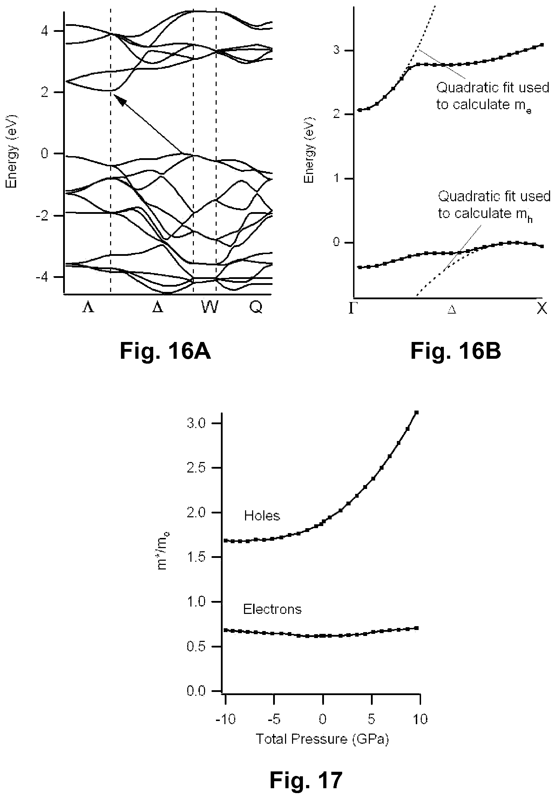

From the anatase structure, there can be derived the full band structure plot shown in Figure 16A. Figure 16B shows an enlarged view of the part of Figure 16A indicated by the arrow, and shows only the top of the valance band and the bottom of the conduction band.

Figure 16B also shows the quadratic fits used to calculate the effective mass of the holes and electron charge carriers, denoted $m_h$ and $m_e$ respectively.

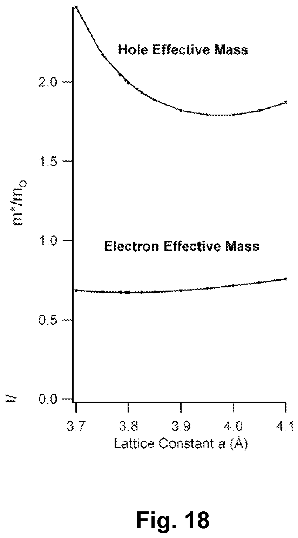

From plots such as those shown in Figure 16B, the variation of the effective mass of the holes and electrons with applied pressure can be calculated, and the result is shown in Figure 17 (Figure 18 shows the results versus lattice constant); note that in Figure 17 the total pressure is non-uniform to induce biaxial strain. From this Figure, it will be seen that (as expected) the effective mass of the electrons varies very little with pressure within the pressure region of practical interest, but the effective mass of the holes varies markedly with pressure. From Figure 17, it will be seen that anatase subjected to negative pressures (i.e., placed until tensile stress) exhibits lowered effective mass of the holes. For reasons mentioned above, lowered effective mass of the charge conductors is desirable since it reduces recombination of electron-hole pairs, and thus further enhances the efficiency of the electrode.

The foregoing theoretical calculations can also show why titania formation, which is the second step of the present process, either by anodizing or thermal oxidation of metallic titanium normally results in titania having its bandgap shifted to higher values, corresponding to the ultra-violet portion of the spectrum. Both types of oxidation essentially force oxygen atoms into the metallic lattice, resulting in a lattice under compressive stress, with a consequently increased bandgap, requiring shorter wavelength radiation for photoactivity and essentially rendering the resulting titania useless for solar radiation based processes.

However, the first step of the present process is to wet etch the titanium substrate to form nanostructures of the desired geometric shape and size. These nanostructures form geometric boundaries that constrain the growth of the titania in the second step, thus giving rise to alternating regions of compression and tension in the resulting titania layer. The present invention is further to control this second step so that the final surface of the titania exposed to the electrolyte is in tension (strain). In this way, we are able to produce in a second step, by anodizing or heat oxidation of metallic titanium, titania having a bandgap shifted toward longer, visible wavelengths.

The aforementioned U.S. Patent No. 7,485,799 teaches nanostructures that are substantially hemispherical or hemicylindrical, as shown in the schematic cross-section in Figure 20A, where one way of forming the nanostructured template for such geometry is the embossing and coating method shown in Figure 19. Figure 20C is a photomicrograph showing actual titania nanostructures that we formed in this way.

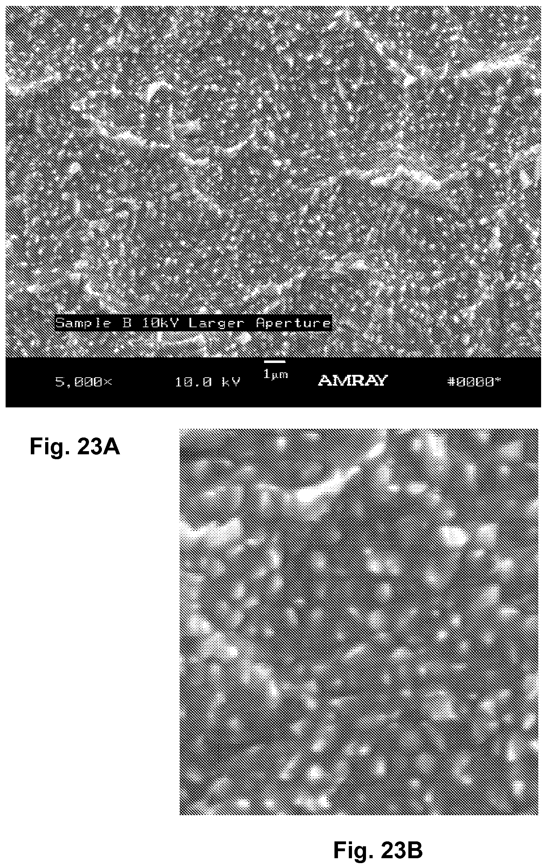

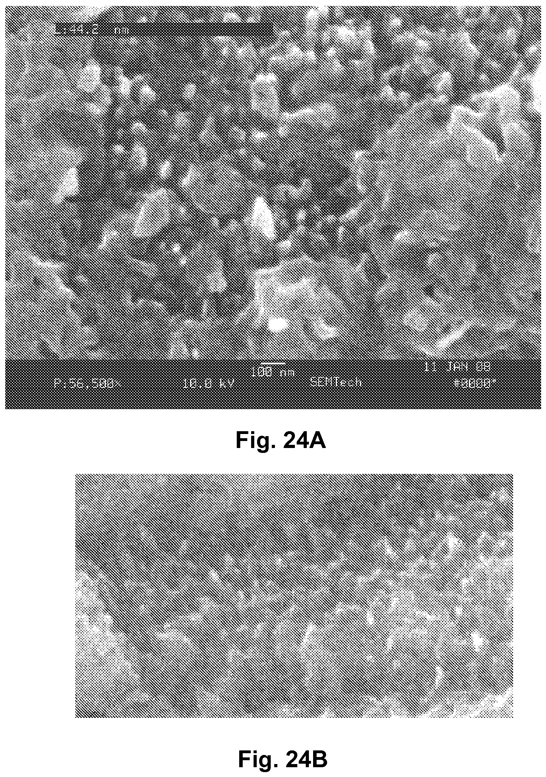

However, we have now found that higher aspect ratio nanostructures spaced from one another so that they are not touching produce much higher levels of strain in the subsequently formed titania layer, and so the bandgap is lowered substantially more than with the hemispherical structures. We have determined this experimentally by forming such structures as are seen in Figure 23A, 23B, 24A and 24B and measuring their bandgap.

Further, we have used The Florida Object Oriented Process Simulator (FLOOPS) to calculate the actual strain levels in various structures including that shown in Fig. 20B. FLOOPS (release 2002 (see M.E. Law and S. Cea, Comp. Mater. Sci. 12, 289 (1998).)) is a finite element analysis tool for simulating many of the process steps typically employed for the development of silicon-based integrated circuit devices (Copyright Mark Law, University of Florida Electrical and Computer Engineering department). Of particular interest to us is the stress computation during simulation of the thermal oxidation of silicon. The thermal oxidation model described in B. E. Deal and S. Grove, J. Appl. Phys. 36, 3770 (1965) forms the basis of the FLOOPS simulation. Although this model was developed for the thermal oxidation of silicon, it can be applied to titanium for temperatures greater than 500°C. Titanium oxidizes at a much higher rate than silicon, but the functional time dependence is very similar. Therefore, adaptation of the model to simulate thermal oxidation of titanium is largely a change in the rate constants of the model. The stress computations in FLOOPS relate stress and strain through a viscoelastic constitutive equation. This is essentially achieved by modification of Hooke's law to include a temperature dependent viscosity, or damping, term. Hooke's law relates stress and strain by a stiffness matrix that is a function of the material crystal symmetry and mechanical properties (Young's modulus and Poisson's ratio). Simply changing the mechanical parameters from the default silicon and silicon dioxide values to the appropriate values for titanium and titanium dioxide provides a simple first order means to adapt stress computations to our system. Stress computations within the oxide layer are reported using a Young's modulus of 204.06 GPa and a Poisson's ratio of 0.31. To our knowledge there exists no reported experimental measurement of the Poisson's ratio(s) for the anatase polymorph of titania, but our results to date indicate that the stress computation is not strongly dependent on this parameter. The stress is reported as a total pressure by using the standard definition of averaging the longitudinal components (familiar extension and compression components of the stress matrix as opposed to shear terms).

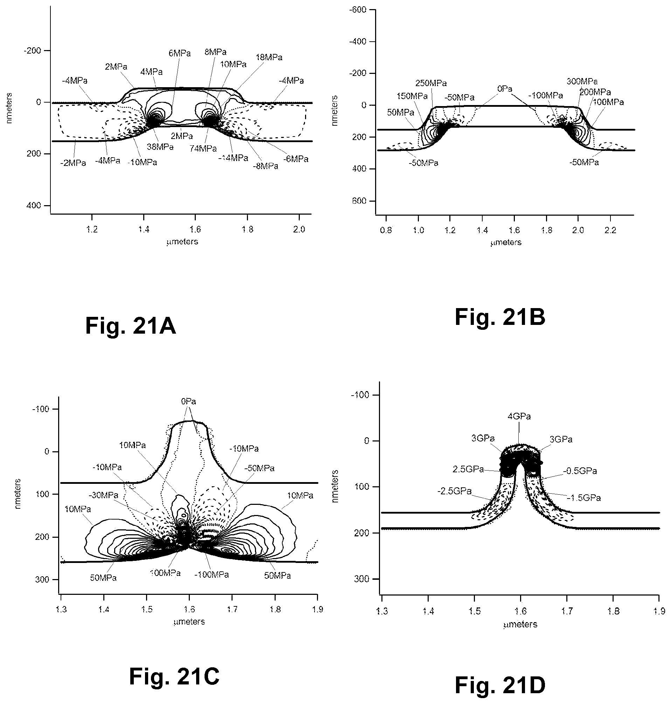

We simulated the thermal oxidation process using FLOOPS with the modifications to the mechanical parameters as described. Our investigation characterizes how non-planar geometric features on the titanium substrate introduce stress into the titania thin film formed during the thermal oxidation process. Figures 21A-21D show some key calculations. In particular, Figure 21D shows a nanostructure that resulted from a 100nm wide starting point, very similar to the nano-structures that have been produced experimentally. As expected, alternating regions of tension and compression are generally formed. Large tensile stress is typical around outer corners while compressive regions are characteristic of inner corners. As in Figure 21D, substrates with small features in the range of 100 nm and short oxidation times are predicted to be highly stressed. Tensile stresses on the order of 4 GPa are seen near the apex of the structure. The stress is predicted to decrease dramatically as the film thickness increases and for features with low aspect ratio. Also, because the stress is concentrated around corners, or transitions, in the substrate, wider features will have fewer transitions and concomitantly less overall stress throughout the film. Final optimizations, including the introduction of periodicity, sharpness of the corners, and 3-dimensional hexagonal arrays are expected to further enhance the magnitude of the stress.

As already mentioned, the first step of this process is formation of nano-structures by wet etching of titanium metal, preferably in the form of a thin sheet, typically having a thickness in the range of about 0.07 to 0.5 mm. Since only a small depth of the titanium surface is converted to photoactive titania on the titanium electrode, an excessively thick sheet wastes titanium metal; however, too thin a sheet may be easily damaged during processing and is more costly due to the extended rolling process required to make it thin. As discussed in more detail below, the presently preferred commercial titanium film is 0.25 mm thick.

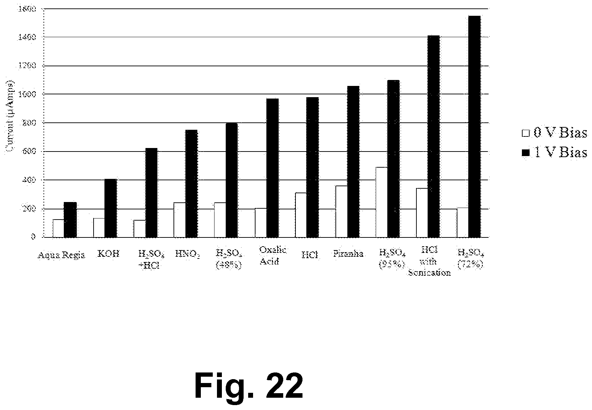

The goal of the wet etching is to produce in the titanium sheet nano-structures having these desired features: mean diameter of about 100 nm, high aspect ratio of at least 1:1, and some space between adjacent nano-structures. Further, it is desired to have a tight distribution of sizes. The acid etching may, so far as is presently known, be effected using any strong acid capable of rapidly etching titanium metal, although obviously acids which deposit insoluble titanium salts of the film should be avoided. Figure 22 is a bar chart showing the photocurrent at zero volts bias (black outlined white bars) and at 1 volt bias (black filled bars). All samples were Grade 1 titanium and were all heat oxidized in the same way, but were first etched in various etching acid solutions as indicated. Because it yields the highest photocurrent (i.e., hydrogen production) at 1 volt bias with good photocurrent at zero volts bias, the presently preferred acid is sulfuric acid, which may be used at concentrations above about 93 per cent, and preferably in the range of about 93 to about 98 per cent. The sulfuric acid etch may be carried out at a temperature in the range of about 60 to about 100°C, and preferably about 75 to about 85°C. To ensure accurate control of the etching process, the process should be carried out for a predetermined period beginning with the onset of active etching as indicated by visible bubble formation. The optimum etching period for any particular combination of etchant type and concentration, temperature and specific titanium film may readily be determined empirically, but etching times will typically be in the range of about 60 to 600 seconds. In the presently preferred etching process, sulfuric acid is used for etching at a concentration of temperature of 93 to 98 per cent at 80°C for 210 seconds from the onset of bubble formation.

Hydrochloric acid can also be used in the wet etching step. Although hydrochloric acid produces satisfactory nano-structures and, as can be seen in the bar chart in Figure 22, good resulting photocurrent as well, it leaves the titanium surface blackened due to the formation of a titanium hydride layer, which should be removed prior to anodization or heat oxidation since it interferes with formation of an oxide layer, and reduces adhesion of the oxide layer to the underlying titanium metal. The hydride layer may readily be removed by sonication. It is also possible to form the hydride layer with sulfuric acid, but the resulting layer is either dissolved subsequently by the same sulfuric acid, or is easily wiped off. Therefore, our preferred embodiment is to use the sulfuric acid etch as described above, with other satisfactory etchants including the "Piranha" solution, oxalic acid, weaker sulfuric acid such as 48% concentration, and even nitric acid. However, potassium hydroxide and Aqua Regia gave unfavorable photocurrent results.

Hitherto, it seems to have been assumed that very pure titanium was required for the formation of high efficiency titania photoactive electrodes. The present inventors have found this not only to be untrue, but that "commercially pure" forms of titanium metal are preferred for use in the etching and titania forming processes of the present invention because they react with the etchant to naturally give rise to the desired spacing between the nanostructures as illustrated in Figure 20B and imaged in Figures 23A, 23B, 24A, and 24B. However, of the commercially pure grades, only Grade 1 titanium having the following specification by weight:

C 0.1 % maximum
Fe 0.2 % maximum
H 0.015 % maximum
N 0.03 % maximum
O 0.18 % maximum
Ti 99.5 % minimum, up to about 99.6 %

or "Grade 2 titanium", which are orders of magnitude less costly than pure titanium, give the desired results. Grade 2, which is available commercially from a variety of suppliers is defined (see for example ASTM B863-06a) as meeting the following specification by weight:

C 0.1 % maximum
Fe 0.3 % maximum
H 0.015 % maximum
N 0.03 % maximum
O 0.25 % maximum
Ti 99.2 % minimum, up to about 99.6 %

It appears that the impurities in Grade 1 or Grade 2 titanium actually improve the formation of nano-structures during acid etching because the impurities work with the etching process to create lands between the nano-structures that were not attainable with pure titanium foil, which in turn increases stress and pushes the bandgap edge further into the visible. In addition, the aspect ratio of the nano-structures is much improved, being taller than they are wide, with a nearly triangular cross section. Achieving such desired structures with pure titanium foil, and with any other process, would be very difficult, very costly, or would not lend itself to mass manufacturing. Furthermore, the electrodes produced by the process of the present invention are expected to have a lifetime of decades, and this process is less costly and has lower energy requirements than prior art processes.

The differences between the types of nano-structures produced by the process of the present invention and that described in the aforementioned U.S. Patent No. 7,485,799 are illustrated in Figures 20A and 20B. Figure 20A shows a typical profile of a titania layer formed by deposition on to a shaped substrate having a continuous series of hemicylindrical ridges. The nano-structures are substantially hemicylindrical with no gaps between adjacent ridges. In contrast, Figure 20B shows a typical profile of a titania layer formed by the acid etching/oxidation process of the invention. The nano-structures have the form of narrow high aspect ratio, even triangular prisms in some cases, separated by wide lands (scanning electron micrographs of such actual structures are seen in Figures 23A, 23B, 24A and 24B).

As discussed, the presently preferred titanium film for use in the process of the invention is the Grade 1 titanium that is also sold as "99.5 % purity annealed titanium foil" 0.25 mm thick by Alfa Aesar, 26 Parkridge Road, Ward Hill MA 01835 under Stock No. 10385. Both Grade 1 and Grade 2 foils were also obtained from Allegheny Technologies Incorporated, 1000 Six PPG Place, Pittsburgh, PA 15222-5479.

As in many other etching processes, to achieve consistent results in the etching step of the second process of the invention, it is necessary to ensure that the titanium surface is clean and free from grease and other materials which might hinder the etching process. The preferred procedure for ensuring a clean titanium surface is, in this order, a soap and water scrub, an acetone soak, a methanol soak and a distilled water rinse. Ultrasonic cleaning is also used in this procedure.

Figure 22 compares the peak photocurrent, which indicates peak hydrogen production, for titania electrodes produced using several different etching compositions. The photocurrent is shown at zero bias voltage as well as 1 volt bias (direct current) for each recipe. All etching was performed at the optimum temperature and time for that particular etchant, which is typically 60-70°C and about 3 minutes for sulfuric acid and 10-15 minutes for hydrochloric acid; the second step of thermal oxidation was constant for all of the samples. It can be seen from Figure 22 that the best performance is obtained with a sulfuric acid etch at 72% concentration, with the sample etched with hydrochloric acid a close second at 1 VDC bias but better at 0 VDC bias. It is important to ultrasonically clean the hydrochloric acid-etched substrate to obtain best results. Other good etching compositions include etching with sulfuric at 95% concentration, Pirhana etch, and hydrochloric and oxalic acid etches without sonification. Figures 23A and 23B show the resulting nanostructures with the sulfuric acid etch, and Figures 24A and 24B show the resulting nanostructures with the hydrochloric acid etch. It is important to note that obtaining these particular structures is not random but is the result of substantial empirical work, as it is quite easy to produce nano-tubes and other structures that do not work in the second step of the process of the present invention.

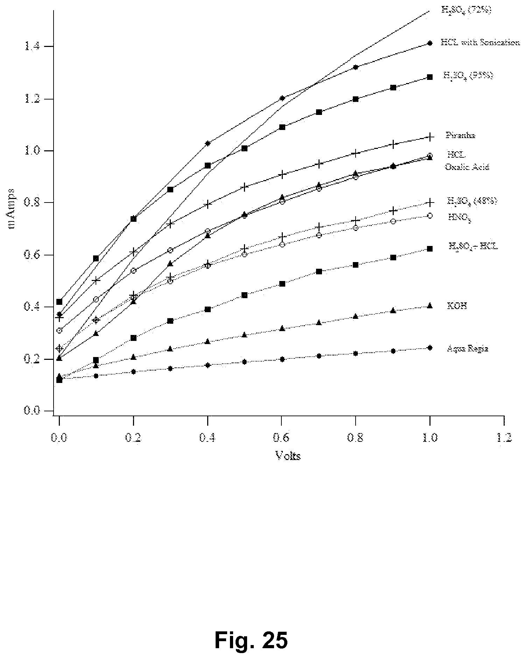

Figure 25 shows the complete IV curves, or current versus voltage plots, for each of the etching compositions used in Figure 22.

The second step of the process of the present invention is, as already mentioned, at least partial conversion of the titanium film to titania, desirably by a process which ensures at least a significant proportion of the anatase form of titania. This conversion of titanium to titania may be effected by anodizing (i.e., making the titanium the anode in an acid solution) or by oxidation. Although thermal oxidation is presently preferred, the anodizing process is useful in applications where the nano-structured substrate cannot be made heat resistant enough to withstand the thermal oxidation process, and the anodizing process will be described first.

Although electrochemical anodizing of titanium metal to form titania coatings is known, the form of titania produced is typically not the anatase photoactive form. Therefore, in the prior art a titania layer has been formed by anodizing, and then heated to form anatase. This process cannot be carried out on many substrates, and is very energy-consuming. It has now been found that anodizing can produces significant anatase in the resultant titania film, as verified with X-ray diffraction analysis, while not exceeding 80°C.

Although, as in the acid etching step, any acid capable of anodizing titanium metal may be used, the preferred acid is sulfuric acid, used at a dilution such that the pH is in the range of about 1.5 to about 2.5, and preferably about 2. The anodizing may be carried out at a temperature about 60 to about 100°C and preferably about 80°C. Satisfactory anodization typically requires the use of a voltage in the range of about 70 to about 100 Volts. A voltage of this order is not a problem when anodizing the surface of thick titanium samples. However, for some applications for this invention, such as air or water purification, it is preferred to apply a thin coating or film of titanium to a nano-structured substrate. This is because the large areas required for lining air ducts, for example, for air purification would be cost-prohibitive even using Grade 1 or Grade 2 titanium foils. On the other hand, the roll-to-roll manufacturing process can economically coat a web of polycarbonate with a thin film of titanium in a box vacuum coater. That titanium coated substrate can then be run through an anodizing bath to effect the titania film atop the titanium base film. When that substrate is polycarbonate, for example, or other electrically insulating and non- heat resistant substrate, anodizing this preferred thin titanium film with the present process often damaged the substrate by resistance heating and/or arcing during anodizing, the heat from which in turn would damage the substrate (cracking glass substrates or melting polycarbonate substrates). It was found that damage to thin films caused by arcing or other undesirable effects caused by rapid voltage changes could be avoided by ramping the voltage to its final value, rather than increasing the voltage stepwise. Alternatively, a short power ramped step could be followed by a longer duration voltage ramped step. An optimum voltage ramp followed the formula:

$$V = V_{Final}\left(1 - e^{-at}\right)$$

where a is an arbitrary constant.

The presently preferred anodizing step uses a voltage ramp of this type with:

$$V_{Final} = 80 \text{ Volts}$$

$$a = 0.4$$

$$\text{total time} = 1 \text{ hour.}$$

The electrolyte was dilute sulfuric acid, pH 2.0 at 80 degrees C. $V_{Final}$ equal to 80 Volts was optimum, but a range between 70-95 Volts resulted in samples not significantly lower in quality for use as photoactive electrodes. Above 90 Volts, the "a" parameter was typically reduced to 0.05 to slow down the voltage rise time to prevent current limitation with the power supply used, which was a KEPCO ATE 150-7M power supply (available from Kepco, Inc. 131-38 Sanford Avenue, Flushing NY 11355).

Substrate pretreatment was found to have only a minor impact on the final topography of the anodized films. AFM (Atomic Force Microscopy) results indicated that the final surface looked nearly identical regardless of pretreatment, whether etching, mechanical polishing, or electro-polishing. (The mechanical polishing and electro-polishing in this case were not alternatives to acid etching for forming the nano-structures, but were rather included as an experimental control, which was a smooth surface). Nevertheless, the substrate pretreatment did improve the band-gap shift for this application by shifting it into the visible.

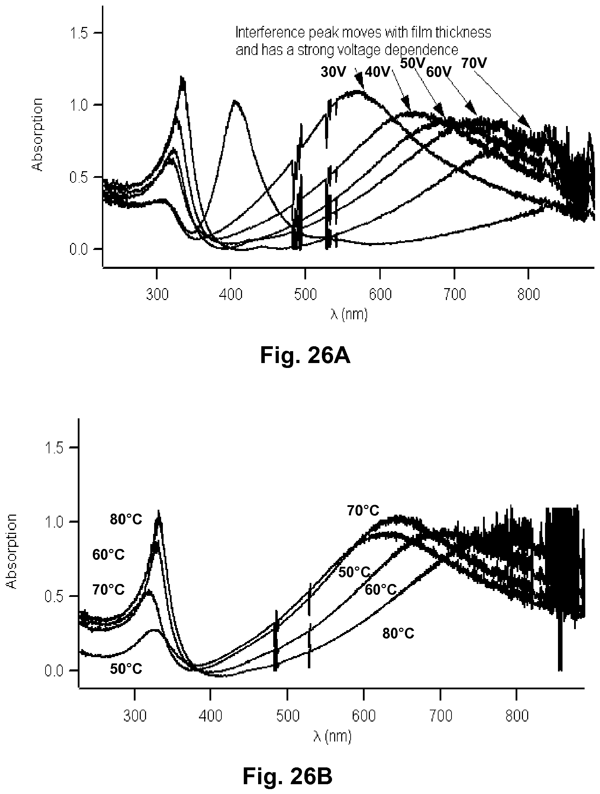

The effects of anodizing temperature and voltage are illustrated in Figures 26, 27 and 28. The aforementioned Alfa Aesar titanium films were acid etched using the preferred sulfuric acid etch described above, and were then anodized using the preferred sulfuric acid medium and ramped operating voltage, but with varying final voltages. The optical absorption of each film was then measured over the range of 250 to 900 nm. Figure 26A shows the results obtained using final voltages of 30, 40, 50, 60, 70 and 80 V, all at a temperature of 70°C Figure 26B shows the results obtained using temperatures of 50, 60, 70 and 80°C, all at a final voltage of 80 V. From Figure 26A, it will be seen that as the final voltage is increased, the absorption interference peak, which depends upon the thickness of the titania film produced by anodizing, increases in height and shifts to shorter wavelengths. Similarly, Figure 26B shows that as the temperature increases the absorption interference peak increases in height and shifts to shorter wavelengths. The resultant ability to control the absorption peak by control of the temperature and final voltage of anodizing allow fine tuning of the absorption peak to coincide with the bandgap of the titania produced by anodization, thus improving the efficiency of the photoactive electrode.

Figure 27 shows X-ray diffraction patterns of titanium films anodized at various temperatures and voltages as noted in the Figure; the anatase peak (or rather shoulder) is marked. Figure 27 indicates that the amount of anatase produced increases with increases in anodizing temperature and voltage.

Figures 28A and 28B are graphs showing the variation of anodizing current with time for (in Figure 28A) a constant electrolyte temperature of 70°C and various applied voltages, and (in Figure 28B) a constant voltage of 80 V and various electrolyte temperatures. The onset of anatase formation is indicated by a sudden increase in anodizing current, and is marked by the arrows in Figures 28A and 28B. Figure 28A shows no anatase formation at 30, 40 and 50 V, and shows that at higher voltages the onset of anatase formation begins more quickly the higher the applied voltage. Figure 28B shows no anatase formation at 50°C, and that at higher temperatures anatase formation begins more *slowly* with increasing temperature.

Finally, Figure 29 shows X-ray diffraction scans of two different anodized films. All three scans confirm that both titanium metal and anatase is present in the anodized films.

As already indicated, the preferred anodizing process requires a complicated, asymptotic voltage against time profile, and to enable such a profile to be followed accurately, a software-controlled interface has been developed that that allows a conventional power supply, such as the aforementioned KEPCO ATE 150-7M power supply, to output arbitrary voltage or current waveforms. The waveforms may be designed by the user through a library of adjustable waveforms or via imported data files. The complete system allows arbitrary voltage or current waveforms to be applied to loads that require more power than commercially available arbitrary waveform generators can generally produce. Software control of the anodizing waveform is needed for two reasons:

1. The power required to produce the anodizing voltage (or current) increases proportionally with the area of the titanium to be anodized. It is desirable to retain the flexibility of arbitrary waveform generation when the load draws high power. Typically, arbitrary waveform generators are not designed for high power applications.

2. Process repeatability is enhanced through software control. It is desirable to create a system capable of reproducing the timing and magnitude of the anodizing waveform to a degree of accuracy that is more sensitive than the dynamics within the anodizing cell. Therefore, the user can be confident that different samples are produced with anodizing waveforms that are virtually identical.

Before these goals were met, the anodizing process was limited by the use of a DC power supply that could produce only constant voltage or current outputs. The optimization of the anodizing waveform was therefore resticted to the magnitude and duration of a square pulse. To achieve these goals, two commercially available instruments were integrated through custom software written in Igor Pro. The first component was the aforementioned KEPCO ATE-7M power supply equipped with controllable output by two analog voltage inputs. The second component was a Stanford Research Systems model SR830 lock-in amplifier, the auxiliary outputs of which were used to supply control voltage inputs to the power supply. The SR 830 is completely controllable via a GPIB (General Purpose Interface Bus) interface to a computer with controlling software. The complete system is therefore IGOR Pro software (WaveMetrics, Inc., 10200 SW Nimbus Ave., Suite G-7, Portland, Oregon 97223) that controls the lock-in amplifier, that in turn controls the KEPCO power supply that produces the system output. The KEPCO power supply is rated for a maximum output of 1050 Watts at 150 volts and seven amperes, which comfortably exceeds the power required for the anodizing application. Additionally, the controllable output achieves the arbitrary waveform generation requirement. The auxiliary voltage outputs of the lock-in amplifier are software controllable to 1 mV. When controlled by an external voltage source, the KEPCO operates as an inverting amplifier with a gain of 15; the magnitude of the system output is then controllable to 15 mV. The speed of lock-in amplifier response to control commands, although not explicitly specified, exceeds the rates at which the commands can be sent. Timing of the control waveform is then limited by the computer processor, which executes the timing loops of the IGOR code. These specifications for accuracy of the output waveform meet the reproducibility objective stated earlier.

The IGOR Pro code serves as the main controller of the system output in two respects. The background tasks of the code manage the GPIB communication with the lock-in amplifier, making the code responsible for the magnitude and timing accuracy of the system output. Secondly, two user-friendly GUIs (Graphic User Interfaces) allow the generation of arbitrary waveforms for the system output. The program provides a library of waveforms that the user can appropriately alter to produce nearly any desired waveform through a piecewise concatenation process. Use of standard Igor data importing capabilities can be used as an additional source for waveforms that have been recorded to file. The overall system behaves similarly to a commercially available arbitrary waveform generator. However, it is unique in its output capabilities that are tailored to anodizing systems. The complete system provides a highly versatile, yet simple, environment for anodizing experimentation. Anodizing systems generally require higher power than is available directly from a waveform generator. By controlling the output of a KEPCO DC power supply, high frequency performance is sacrificed to gain much higher output power.

The software that generates the anodizing waveforms has unique features. The library of adjustable waveforms may be expanded programmatically to include additional waveforms that are of specific interest to anodizing systems. In addition, since the software is customized for this system, the output waveform may be automatically scaled to serve as proper control input signals for the KEPCO ATE supply. Testing the system accuracy is a simple matter of comparing the desired output to the real output. The real output is recorded by an oscilloscope or chart recorder and loaded into the Igor software. Visual inspection is generally adequate to determine if the output matches the input. The known sources of error include:

1. Timing errors from software; the main challenge of the software is to properly manage the delay between points (dt) of the output waveform. The minimum dt limits the highest frequency of the waveform achievable at the output. The output accuracy degrades as the waveform frequency increases, and manifests itself as output that appears discretized.
2. Hardware limitations; as described previously, the voltage magnitude is controllable to within 15 mV due to the 1 mV accuracy of the SR830 voltage source. Other sources of error are due to limitations of the power supply. These errors are typically negligible but may be noticeable for large step changes in voltage due to the finite response time of the supply. The power supply may be configured to have a faster response time, but the output will be more oscillatory.

The accuracy of the voltage control which can be achieved with the preferred system described above can be seen from Figure 30, in which the blue line represents the (complex) recorded voltage waveform of successful anodization process derived empirically and recorded on a computer-based chart recorder, while the red area represent the results of using the same waveform to drive the preferred system described above and measuring the output of the power supply during an anodizing process. It will be seen that the original waveform and the final controlled output are identical.

Preferred processes for heat oxidation of acid etched titanium films to titania films containing anatase will now be described. One problem with heat oxidation of titanium films is that the desired anatase crystal form begins to form at about 450°C in air, but at this temperature the rate of oxidation is too low to be practically useful. At about 700°C, the rate of oxidation becomes rapid enough for large scale production processes, but the rutile crystal form typically predominates. However, it has now been found that titania films, containing a sufficient proportion of anatase to act as efficient photoactive catalysts, can be produced by heating acid etched titanium films in air, with or without added oxygen, to about 700°C for a relatively brief period of less than about 1 hour, and desirably in the range of about 20 to about 45 minutes; the optimum heating period appears to be typically about 30 to about 35 minutes, which results in good anatase formation. Excessive heating times tend to lead to a high proportion of the undesirable rutile crystal form. It has been found that heating to about 700°C for a relatively brief period produces photoactive electrodes with high efficiency and long operating lifetimes. The process is highly versatile, allowing formation of titania films containing varying proportions of amorphous titania, anatase and rutile. The quality of the titania films produced is more sensitive to variations in the acid etching step and the heat oxidation step than is the case where acid etching is followed by anodization.

Such heating of acid etched titanium films will typically be carried out in a furnace; one furnace which has been found to give good results is a Barnstead Thermoline Model FB1315M, available form Barnstead International, 2555 Kerper Boulevard, Dubuque IA 52001-1478. A tubular furnace may alternatively be used. It is desirable that the furnace be modified to allow gases, such as nitrogen and oxygen to be introduced into the heating chamber of the furnace. The temperature and the time of heating have the most significant impact on the quality of the final photoactive electrode, and electrode quality is highly sensitive to these variables.

Typically, the acid etched titanium film is introduced into the furnace at a temperature lower than the actual heat treatment temperature of 690°C; for example, the films may be added to the furnace at 500°C. The furnace temperature is then raised to the actual heat treatment temperature; the titania films produced do not appear to be very sensitive to either the temperature at which the titanium films are introduced to the furnace or the rate at which the furnace temperature is raised. Timing of the heat treatment begins only after the furnace has reached the desired heat treatment temperature. For small films of 1.5 cm by 2.5 cm, the air within the furnace provides sufficient oxygen for titania formation but with larger films, such as a coil of a 6 cm by 100 cm strip, it is desirable to introduce additional oxygen into the furnace to ensure that there is enough oxygen to form the desired thickness, uniformity and stoichiometry of the titania layer. It has been found that, in the case of the preferred commercial furnace mentioned above, introducing oxygen at a rate of 5 standard cubic feet per hour (about 142 liters per hour) provides enough oxygen to ensure proper titania formation. Figure 31 shows that the highest photocurrent is obtained with the peak temperature at 690°C for 90 minutes. However, since a decrease in peak photocurrent by even 25% is still commercially viable, the contour in Fig 31 corresponding to 0.9 mA shows that the temperature can be 635 to 735°C at corresponding times of 135 minutes to 40 minutes respectively. Allowing for a decrease in peak photocurrent of 33% to 0.8 mA includes times as short as 10 minutes at 700°C and temperatures as high as 745°C for 30 minutes. The full range of acceptable or commercially viable recipes of time versus temperature are shown in Figure 31.

After the heat treatment, the films can simply be removed from the oven and allowed to stand in air to cool to ambient temperature. The rate of cooling has not been shown to have any measurable effect on the quality or efficiency of the final photoactive electrodes.

**Example 1**

This Example illustrates the effects of illumination conditions, bias voltage and temperature on the efficiency of hydrogen production and conversion efficiency of an apparatus as shown in Figures 1-2 and 7.

An apparatus as described above with reference to Figures 1-2 and 7 was subjected to artificial solar illumination conditions of AM 1.5 and AM 0.0, where AM means Air or Atmospheric Mass, the amount of atmosphere through which the sunlight must travel to reach the ground. So, AM 1.5 is typical for sea level conditions, while AM 0.0 is for a "space" application such as orbiting satellites. with the core assembly 116 maintained at either 25 or 80°C and with varying bias voltages applied between the photoactive anode 226 and the cathode 220. In these tests, the bias voltage was not supplied by the photovoltaic strip 602 (Figure 7) in order to permit the illumination of the photovoltaic strip and the bias voltage to be controlled independently. Figure 32A shows the rate of hydrogen production (measured as the current passing between the electrodes) as a function of bias voltage at 25°C, while Figure 32B shows the conversion efficiency as a function of bias voltage. Figures 32C and 32D parallel Figures 32A and 32B respectively but relate to measurements at 80°C.

From Figures 32A-32D, it will be seen that the rates of hydrogen production and conversion efficiency at 80°C are more than double those at 25°C, and this improved performance with temperature is one major reason for constructing the apparatus so that it is able to operate at elevated temperatures. The improved performance at higher temperatures can be attributed to both bandgap shift and easier electrolysis. In all cases, hydrogen production increases with increasing bias voltage although under low illumination conditions the increase is small. Conversion efficiency tends to increase with bias voltage but eventually reaches a maximum value and thereafter declines.

**Example 2**

This Example illustrates (see Figure 33) the effects of bias voltage on conversion efficiency of an apparatus as shown in Figures 1, 2 and 7, as a function of the electrolyte composition. The best results, i.e. highest hydrogen production efficiency, are obtained with either an acidic electrolyte or a salt water electrolyte. The basic potassium hydroxide electrolyte performs best at zero voltage bias, but underperforms at higher voltage bias.

The photoactive titania electrodes of the present invention can be used in any application in which photoactive titania electrodes have hitherto been used, as discussed in detail in the aforementioned parent application.

In summary, this invention provides for shifting the optical bandgap of a semiconductor into longer optical wavelengths by stressing the semiconductor, where the semiconductor is a thin film, and where the stress is strain caused by some or all of the following: conditions under which the thin film is formed, the shape of the substrate on a nano and micro scale, and the mechanical, chemical, and thermal properties of the substrate. Titania is the preferred semiconductor photocatalytic embodiment, but the invention applies to any semiconductor that is photo-active, such as silicon, germanium, and their alloys, and compounds that include, in addition, gallium. The stress-inducing template profiles also provide a mechanical lock to the coating so that the stress can exist without causing delamination of the coating from the substrate.

The aqueous source of hydrogen for the photoelectrolysis to act on can be water, sea water, an aqueous solution with electrolytes, or non-aqueous hydrogen-bearing liquids such as methanol or gasoline.

The apparatus of the present invention shown in Figures 1, 2 and 7 has a core assembly with cylindrical geometry, and tracks the sun by rotation about one axis. It will readily be apparent that this apparatus could use a core assembly with substantially spherical geometry (alternatively a planar core assembly could be used) which tracks the sun by rotation about two perpendicular axes. While a spherical core requires additional tracking of the sun, it allows for higher solar concentration than a cylindrical core so that smaller reflectors and/or core assemblies can be used.

**Claims**

1.  A process for producing a titania electrode, the process comprising:

    (a) subjecting titanium metal to an acid etchant; and
    (b) oxidizing at least part of the etched titanium to titania by at least one of (i) anodizing the titanium in an anodizing solution, and (ii) heating the titanium in an oxygen-containing atmosphere,

    the process being **characterized in that** step (a) forms a titanium nano-structured surface on the titanium metal, said nano-structured surface having nanostructures of mean diameter about 100 nm and with high aspect ratio of at least 1:1, the nanostructures being spaced apart from one another, and **in that** the titania film produced in step (b) is stressed by the nanostructures, the stress causing the titania film to have a lower bandgap than unstressed titania.

2.  A process according to claim 1 wherein the titanium metal used is an impure form containing not more than 99.6 per cent titanium by weight.

3.  A process according to claim 2 where the titanium is Grade 1 titanium having the following specification by weight:

    C 0.1 % maximum
    Fe 0.2 % maximum
    H 0.015 % maximum
    N 0.03 % maximum
    O 0.18 % maximum
    Ti 99.5 % minimum, up to 99.6 %,

    or Grade 2 titanium having the following specification by weight:

    C 0.1 % maximum
    Fe 0.3 % maximum
    H 0.015 % maximum
    N 0.03 % maximum
    O 0.25 % maximum
    Ti 99.2 % minimum, up to 99.6 %.

4.  A process according to claim 1 wherein step (a) is effected using sulfuric acid having a concentration of at least 93 per cent by weight at a temperature of 60 to 100°C.

5.  A process according to claim 4 wherein the acid etching is carried out for a period of from 60 to 600 seconds from the onset of visible bubbling.

6.  A process according to claim 1 wherein step (b) is effected by heat oxidizing the titanium at a temperature of at least 630°C for a period of not more than 100 minutes.

7. A process according to claim 6 wherein the heat oxidation is effected at a temperature of 635°C to 735°C for a period of 90 to 30 minutes.

8. A process according to claim 1 wherein step (b) is effected by heat oxidizing the titanium in air to which additional oxygen has been added.

9. A process according to claim 1 wherein said titania is predominantly anatase.

10. Photo-reactor core assembly means (116; 116'; 516; 816; 1016; 1116) for carrying out at least one photo-induced reaction, the photo-reactor core assembly means comprising at least one photoactive titania electrode (226; 226'; 226"; 826) produced by a process according to claim 1, said photoactive titania electrode (226; 226'; 226"; 826) being provided with louver openings (404); at least one counter-electrode (220'), at least one septum (350) separating said counter-electrode (220') from said photoactive titania electrode (226; 226'; 226"; 826); electrolyte; and at least one liquid-tight container, at least a portion of which is transparent to at least the electromagnetic wavelengths absorbed by said photoactive titania electrode, so as to provide immersion and containment of said photoactive electrode, counter-electrode, and septum in said electrolyte, and to further contain the reaction products developed at said photoactive titania electrode and counter-electrode.

11. A photo-reactor core assembly means according to claim 10 wherein the septum comprises at least one of open cell foam, polypropylene non-woven felt, polyethylene non-woven felt, polyester non-woven felt, non-woven felt, fluoropolymer membrane, and microporous ceramic or glass frit.

12. A photo-reactor core assembly means according to claim 10 wherein the electrolyte comprises any one or more of aqueous solutions of potassium carbonate, KOH, carbonic acid, carbolic acid, or seawater, or of non-aqueous hydrogen-bearing liquids such as methanol.

13. A photo-reactor core assembly means according to claim 10 wherein the photo-induced reaction comprises any one or more of hydrogen production, oxygen production, reduction of $CO_2$ to CO, synthesis of CO and $H_2$ into $CH_4$, production of chlorine gas and sodium hypochlorite, and heating of the electrolyte.

14. A photo-reactor core assembly means according to claim 10 wherein said container is provided with separate outlets for gaseous products of photoactive electrode and counter-electrode, said outlets further being provided with pressure relief valves (1206, 1208), said pressure relief valves having unequal pressure values so as to affect purity in one or the other gaseous product and also supplying back pressure to the photo-reactor core assembly means.

15. A photo-reactor core assembly means according to claim 10 for carrying out photo-induced reactions with the photoactive titania electrode of claim 1, the photo-reactor core assembly means further comprising:

a primary reflector (110; 610; 1018; 1110) arranged to concentrate radiation incident thereon to a primary focus; a secondary reflector or scattering means (226; 806) disposed at or adjacent the primary focus and arranged to direct radiation incident thereon to a secondary focus; and photovoltaic means (602) for converting radiation to electricity; ,wherein one of the photovoltaic means (602) and the photo-reactor means (116; 116'; 516; 816; 1016; 1116) is disposed at or adjacent the primary focus, and the other of the photovoltaic means and the photo-reactor means is disposed at or adjacent the secondary focus. and wherein the photovoltaic means (602) uses a first wavelength range for converting radiation to electricity and the photo-reactor means (116; 116'; 516; 816; 1016; 1116) uses a second wavelength range at least part of which differs from the first wavelength range, and wherein the secondary reflector or scattering means comprises a wavelength selective reflector or scattering means arranged to reflect or scatter one of the first and second wavelength ranges to the secondary focus. and wherein the photo-reactor core assembly means comprises a counter-electrode (220; 220'; 220"; 820) in addition to the photoactive electrode (226; 226'; 226"; 826), the apparatus further comprising conductors connecting the photovoltaic means (602) to the counter-electrode (220; 220'; 220"; 820) and photoactive electrode (226; 226'; 226"; 826) so that the voltage generated by the photovoltaic means is applied as a bias voltage across the counter-electrode and photoactive electrode.

16. A photo-reactor core assembly means according to claim 15 wherein the primary reflector (610) comprises a flexible reflective sheet and two end caps, the facing surfaces of said end caps being provided with slotted receiving guides of predetermined shape, and the flexible reflective sheet being inserted into the slotted receiving guides so that it follows the shape determined by the guides.

17. Multi-core apparatus photo-reactor means comprising a parallel and coplanar elongate plurality of photo-reactor core assembly means according to claim 10 (1000, 1100) joined by at least one common manifold.

**Patentansprüche**

1. Verfahren zum Herstellen einer Titandioxidelektrode, wobei das Verfahren Folgendes umfasst:

   (a) Aussetzen von Titanmetall einem Säureätzmittel; und
   (b) Oxidieren zumindest eines Teils des geätzten Titans zu Titandioxid durch mindestens eines der Folgenden: (i) Anodisieren des Titans in einer Anodisationslösung und (ii) Erwärmen des Titans in einer sauerstoffhaltigen Atmosphäre,

   wobei das Verfahren **dadurch gekennzeichnet ist, dass** der Schritt (a) eine nanostrukturierte Titanfläche auf dem Titanmetall bildet, wobei die nanostrukturierte Fläche Nanostrukturen mit einem mittleren Durchmesser von ungefähr 100 nm und mit einem großen Längenverhältnis von mindestens 1:1 besitzt, wobei die Nanostrukturen voneinander beabstandet sind, und dadurch, dass die im Schritt (b) hergestellte Titandioxidschicht durch die Nanostrukturen unter Spannung steht, wobei die Spannung bewirkt, dass die Titandioxidschicht eine kleinere Bandlücke als nicht unter Spannung stehendes Titan besitzt.

2. Verfahren nach Anspruch 1, wobei das verwendete Titanmetall eine unreine Form ist, die nicht mehr als 99,6 Gewichtsprozent Titan enthält.

3. Verfahren nach Anspruch 2, wobei das Titan Grad 1-Titan mit den folgenden Gewichtsspezifikationen ist:

   C 0,1 % maximal
   Fe 0,2 % maximal
   H 0,015 % maximal
   N 0,03 % maximal
   O 0,18 % maximal
   Ti 99,5% minimal bis zu 99,6 %

   oder Grad 2-Titan mit den folgenden Gewichtsspezifikationen ist:

   C 0,1 % maximal

Fe 0,3 % maximal
H 0,015 % maximal
N 0,03 % maximal
O 0,25% maximal
Ti 99,2 % minimal bis zu 99,6 %.

4. Verfahren nach Anspruch 1, wobei der Schritt (a) unter Verwendung von Schwefelsäure mit einer Konzentration von mindestens 93 Gewichtsprozent bei einer Temperatur von 60 bis 100 °C ausgeführt wird.

5. Verfahren nach Anspruch 4, wobei das Säureätzen für eine Dauer von 60 bis 600 Sekunden ab dem Einsetzen einer sichtbaren Blasenbildung ausgeführt wird.

6. Verfahren nach Anspruch 1, wobei der Schritt (b) durch Wärmeoxidieren des Titans bei einer Temperatur von mindestens 630 °C für eine Dauer von nicht mehr als 100 Minuten ausgeführt wird.

7. Verfahren nach Anspruch 6, wobei die Wärmeoxidation bei einer Temperatur von 635 °C bis 735 °C für eine Dauer von 90 bis 30 Minuten ausgeführt wird.

8. Verfahren nach Anspruch 1, wobei der Schritt (b) durch Wärmeoxidieren des Titans in Luft, die zusätzlich mit Sauerstoff angereichert wurde, ausgeführt wird.

9. Verfahren nach Anspruch 1, wobei das Titandioxid vorwiegend Anatas ist.

10. Photoreaktorkernherstellungsmittel (116; 116'; 516; 816; 1016; 1116) zum Ausführen mindestens einer photoinduzierten Reaktion, wobei die Photoreaktorkernherstellungsmittel Folgendes umfassen: mindestens eine photoaktive Titandioxidelektrode (226; 226'; 226"; 826), die durch ein Verfahren nach Anspruch 1 hergestellt ist, wobei die photoaktive Titandioxidelektrode (226; 226'; 226"; 826) mit Rasteröffnungen (404) ausgestattet ist; mindestens eine Gegenelektrode (220'), mindestens eine Trennwand (350), die die Gegenelektrode (220') von der photoaktiven Titandioxidelektrode (226; 226'; 226"; 826) trennt; ein Elektrolyt; und mindestens einen flüssigkeitsdichten Behälter, von dem mindestens ein Teil mindestens bis zu den elektromagnetischen Wellenlängen, die durch die photoaktive Titandioxidelektrode absorbiert werden, lichtdurchlässig ist, um eine Versenkung und ein Einschließen der photoaktiven Elektrode, der Gegenelektrode und der Trennwand in dem Elektrolyt zu liefern und um weiter die Reaktionsprodukte, die an der photoaktiven Titandioxidelektrode und der Gegenelektrode entwickelt werden, zu enthalten.

**11.** Photoreaktorkernherstellungsmittel nach Anspruch 10, wobei die Trennwand einen offenporigen Schaumstoff und/oder einen nicht gewebten Polypropylenfilz und/oder einen nicht gewebten Polyethylenfilz und/oder einen nicht gewebten Polyesterfilz und/oder einen nicht gewebten Filz und/oder eine Fluorpolymermembran und/oder Glasmasse umfasst.

**12.** Photoreaktorkernherstellungsmittel nach Anspruch 10, wobei der Elektrolyt eine oder mehrere wässrige Lösungen von Kaliumkarbonat, KOH, Kohlensäure, Karbolsäure oder Seewasser oder nicht wässrige wasserstofftragende Flüssigkeiten wie etwa Methanol umfasst.

**13.** Photoreaktorkernherstellungsmittel nach Anspruch 10, wobei die photoinduzierte Reaktion eine oder mehrere von Wasserstoffproduktion, Sauerstoffproduktion, Reduktion von $CO_2$ zu CO, Synthese von CO und $H_2$ in $CH_4$, Produktion von Chlorgas und Natriumhypochlorit und Erwärmen des Elektrolyts umfasst.

**14.** Photoreaktorkernherstellungsmittel nach Anspruch 10, wobei der Behälter mit getrennten Auslässen für gasförmige Produkte der photoaktiven Elektrode und der Gegenelektrode ausgestattet ist, wobei die Auslässe ferner mit Druckentlastungsventilen (1206, 1208) ausgestattet sind, wobei die Druckentlastungsventile ungleiche Druckwerte besitzen, um die Reinheit in dem einen oder dem anderen gasförmigen Produkt zu beeinflussen und außerdem Druck an die Photoreaktorkernherstellungsmittel zurückzuliefern.

**15.** Photoreaktorkernherstellungsmittel nach Anspruch 10 zum Ausführen von photoinduzierten Reaktionen mit der photoaktiven Titandioxidelektrode nach Anspruch 1, wobei die Photoreaktorkernherstellungsmittel ferner Folgendes umfassen:

einen primären Reflektor (110; 610; 1018; 1110), der ausgelegt ist, auf ihn einfallende Strahlung auf einen primären Brennpunkt zu konzentrieren;
einen sekundären Reflektor oder Streumittel (226; 806), die an dem primären Brennpunkt oder an ihn angrenzend angeordnet sind und ausgelegt sind, auf sie einfallende Strahlung auf einen zweiten Brennpunkt zu lenken;
und photovoltaische Mittel (602) zum Umsetzen von Strahlung in Elektrizität;
wobei die photovoltaischen Mittel (602) oder die Photoreaktormittel (116; 116'; 516; 816; 1016; 1116) an dem primären Brennpunkt oder in dessen Nähe angeordnet sind und die anderen der photovoltaischen Mittel und der Photoreaktormittel an dem sekundären Brennpunkt oder in dessen Nähe angeordnet sind,
und wobei die photovoltaischen Mittel (602) einen ersten Wellenlängenbereich zum Umsetzen von Strahlung in Elektrizität verwenden und die Photoreaktormittel (116; 116'; 516; 816; 1016; 1116) einen zweiten Wellenlängenbereich verwenden, wovon zumindest ein Teil von dem ersten Wellenlängenbereich verschieden ist, und wobei der sekundäre Reflektor oder die Streumittel einen wellenlängenselektiven Reflektor oder wellenlängenselektive Streumittel umfassen, die ausgelegt sind, den ersten oder den zweiten Wellenlängenbereich zu dem sekundären Brennpunkt zu reflektieren oder zu streuen,
und wobei die Photoreaktorkernherstellungsmittel zusätzlich zu der photoaktiven Elektrode (226; 226'; 226"; 826) eine Gegenelektrode (220; 220'; 220"; 820) umfassen, wobei die Vorrichtung ferner Leiter umfasst, die die photovoltaischen Mittel (602) mit der Gegenelektrode (220; 220'; 220"; 820) und der photoaktiven Elektrode (226; 226'; 226"; 826) verbinden, so dass die durch die photovoltaischen Mittel erzeugte Spannung als eine Vorspannung über die Gegenelektrode und die photoaktive Elektrode angelegt wird.

**16.** Photoreaktorkernherstellungsmittel nach Anspruch 15, wobei der primäre Reflektor (610) eine flexible reflektierende Folie und zwei Endkappen umfasst, wobei die zugewandten Flächen der Endkappen mit geschlitzten Aufnahmeführungen einer vorgegebenen Form ausgestattet sind und die flexible reflektierende Folie in die geschlitzten Aufnahmeführungen eingefügt wird, so dass sie der durch die Führungen bestimmten Form folgt.

**17.** Mehrkernvorrichtung-Photoreaktormittel, die mehrere parallele und komplanare langgestreckte Photoreaktorkern-Herstellungsmittel nach Anspruch 10 (1000, 1100), die mit mindestens einem gewöhnlichen Mehrfachverteiler verbunden sind, umfassen.

## Revendications

**1.** Procédé pour la production d'une électrode en dioxyde de titane, le procédé consistant à :

(a) soumettre du titane métallique à un agent d'attaque chimique acide ; et
(b) oxyder au moins une partie du titane chimiquement attaqué en dioxyde de titane par au moins un processus parmi

(i) l'anodisation du titane dans une solution d'anodisation et

(ii) le chauffage du titane dans une atmosphère contenant de l'oxygène,

le procédé étant **caractérisé en ce que** l'étape (a) forme une surface nanostructurée en titane sur le titane métallique, ladite surface nanostructurée ayant des nanostructures de diamètre moyen d'environ 100 nm et présentant un rapport de forme élevé d'au moins 1:1, les nanostructures étant à distance les unes des autres, et **en ce que** le film de dioxyde de titane produit dans l'étape (b) est soumis à une contrainte par les nanostructures, la contrainte amenant le film de dioxyde de titane à avoir une plus faible bande d'énergie interdite que du dioxyde de titane non soumis à une contrainte.

2. Procédé selon la revendication 1 dans lequel le titane métallique utilisé est une forme impure ne contenant pas plus de 99,6 pour cent de titane en poids.

3. Procédé selon la revendication 2 dans lequel le titane est du titane de grade 1 ayant la spécification suivante en poids :

0,1 % au maximum de C
0,2 % au maximum de Fe
0,015 % au maximum de H
0,03 % au maximum de N
0,18 % au maximum de O
99,5 % au minimum et jusqu'à 99,6 % de Ti,

ou du titane de grade 2 ayant la spécification suivante en poids :

0,1 % au maximum de C
0,3 % au maximum de Fe
0,015 % au maximum de H
0,03 % au maximum de N
0,25 % au maximum de O
99,2 % au minimum et jusqu'à 99,6 % de Ti.

4. Procédé selon la revendication 1 dans lequel l'étape (a) est effectuée à l'aide d'acide sulfurique ayant une concentration d'au moins 93 pour cent en poids à une température de 60 à 100 °C.

5. Procédé selon la revendication 4 dans lequel l'attaque chimique à l'acide est mise en oeuvre pendant une durée de 60 à 600 secondes à partir du début de la formation visible de bulles.

6. Procédé selon la revendication 1 dans lequel l'étape (b) est effectuée par oxydation thermique du titane à une température d'au moins 630 °C pendant une durée de pas plus de 100 minutes.

7. Procédé selon la revendication 6 dans lequel l'oxydation thermique est effectuée à une température de 635 °C à 735 °C pendant une durée de 90 à 30 minutes.

8. Procédé selon la revendication 1 dans lequel l'étape (b) est effectuée par oxydation thermique du titane dans de l'air auquel de l'oxygène supplémentaire a été ajouté.

9. Procédé selon la revendication 1 dans lequel ledit dioxyde de titane est principalement de l'anatase.

10. Moyen ensemble de coeur de photoréacteur (116 ; 116' ; 516 ; 816 ; 1016 ; 1116) pour la mise en oeuvre d'au moins une réaction photo-induite, le moyen ensemble de coeur de photoréacteur comprenant au moins une électrode photoactive en dioxyde de titane (226 ; 226' ; 226" ; 826) produite par un procédé selon la revendication 1, ladite électrode photoactive en dioxyde de titane (226 ; 226' ; 226" ; 826) étant pourvue d'ouvertures à lames (404) ; au moins une contre-électrode (220'), au moins un septum (350) séparant ladite contre-électrode (220') de ladite électrode photoactive en dioxyde de titane (226 ; 226' ; 226" ; 826) ; de l'électrolyte ; et au moins un récipient étanche aux liquides, dont au moins une partie est transparente au moins vis-à-vis des longueurs d'onde électromagnétique absorbées par ladite électrode photoactive en dioxyde de titane, de manière à assurer l'immersion et le confinement de ladite électrode photoactive, de ladite contre-électrode et dudit septum dans ledit électrolyte et à contenir en outre les produits réactionnels générés au niveau desdites électrode photoactive en dioxyde de titane et contre-électrode.

11. Moyen ensemble de coeur de photoréacteur selon la revendication 10 dans lequel le septum comprend au moins un matériau parmi une mousse à alvéoles ouverts, un feutre non tissé en polypropylène, un feutre non tissé en polyéthylène, un feutre non tissé en polyester, un feutre non tissé, une membrane en polymère fluoré et une céramique ou fritte de verre microporeuse.

12. Moyen ensemble de coeur de photoréacteur selon la revendication 10 dans lequel l'électrolyte comprend un quelconque constituant parmi des solutions aqueuses de carbonate de potassium, de KOH, d'acide carbonique, d'acide carbolique ou d'eau de mer ou des liquides non aqueux renfermant de l'hydrogène tels que le méthanol ou plusieurs de ces constituants.

13. Moyen ensemble de coeur de photoréacteur selon la revendication 10 dans lequel la réaction photo-induite comprend une quelconque réaction parmi la production d'hydrogène, la production d'oxygène, la

réduction de $CO_2$ en CO, la synthèse de $CH_4$ à partir de CO et d'$H_2$, la production de chlore gazeux et d'hypochlorite de sodium et le chauffage de l'électrolyte ou plusieurs de ces réactions.

14. Moyen ensemble de coeur de photoréacteur selon la revendication 10 dans lequel ledit récipient est pourvu de sorties séparées pour des produits gazeux de l'électrode photoactive et de la contre-électrode, lesdites sorties étant en outre pourvues de soupapes de décharge (1206, 1208), lesdites soupapes de décharge ayant des valeurs de pression différentes de manière à avoir une incidence sur la pureté dans l'un ou l'autre produit gazeux et appliquant également une contre-pression au moyen ensemble de coeur de photoréacteur.

15. Moyen ensemble de coeur de photoréacteur selon la revendication 10 pour la mise en oeuvre de réactions photo-induites avec l'électrode photoactive en dioxyde de titane selon la revendication 1, le moyen ensemble de coeur de photoréacteur comprenant en outre :

   un réflecteur primaire (110 ; 610 ; 1018 ; 1110) conçu pour concentrer un rayonnement incident vers un foyer primaire ;
   un réflecteur secondaire ou un moyen de diffusion (226 ; 806) disposé au niveau du foyer primaire ou à proximité de celui-ci et conçu pour envoyer un rayonnement incident vers un foyer secondaire ;
   et un moyen photovoltaïque (602) pour la conversion d'un rayonnement en électricité ;

   dans lequel l'un du moyen photovoltaïque (602) et du moyen photoréacteur (116 ; 116' ; 516 ; 816 ; 1016 ; 1116) est disposé au niveau du foyer primaire ou à proximité de celui-ci et l'autre du moyen photovoltaïque et du moyen photoréacteur est disposé au niveau du foyer secondaire ou à proximité de celui-ci et dans lequel le moyen photovoltaïque (602) utilise une première plage de longueur d'onde pour la conversion d'un rayonnement en électricité et le moyen photoréacteur (116 ; 116' ; 516 ; 816 ; 1016 ; 1116) utilise une seconde plage de longueur d'onde dont au moins une partie diffère de la première plage de longueur d'onde
   et dans lequel le réflecteur secondaire ou le moyen de diffusion comprend un réflecteur ou moyen de diffusion sélectif en longueur d'onde conçu pour réfléchir ou diffuser l'une des première et seconde plages de longueur d'onde vers le foyer secondaire,
   et dans lequel le moyen ensemble de coeur de photoréacteur comprend une contre-électrode (220 ; 220' ; 220" ; 820) en plus de l'électrode photoactive (226 ; 226' ; 226" ; 826), l'appareil comprenant en outre des conducteurs connectant le moyen photovoltaïque (602) à la contre-électrode (220 ; 220' ; 220" ; 820) et à l'électrode photoactive (226 ; 226' ; 226" ; 826) de sorte que la tension produite par le moyen photovoltaïque est appliquée en tant que tension de polarisation entre la contre-électrode et l'électrode photoactive.

16. Moyen ensemble de coeur de photoréacteur selon la revendication 15 dans lequel le réflecteur primaire (610) comprend une feuille réfléchissante souple et deux embouts, les surfaces en regard desdits embouts étant pourvues de guides de réception rainurés de forme prédéfinie et la feuille réfléchissante souple étant introduite dans les guides de réception rainurés de sorte qu'elle suit la forme déterminée par les guides.

17. Moyen photoréacteur de type appareil multicoeur comprenant une pluralité de moyens ensembles de coeur de photoréacteur selon la revendication 10 (1000, 1100) allongés parallèles et coplanaires reliés par au moins un distributeur commun.

110

114

100

116

112

Fig. 1

108

106

104

102

**Fig. 2A**

**Fig. 2B**

**Fig. 2C**

**Fig. 3A**

**Fig. 3B**

**Fig. 3C**

Fig. 4

**Fig. 5**

**Fig. 6**

Fig. 7

**Fig. 8**

**Fig. 9**

**Fig. 10**

Fig. 11

**hν**

**H₂0**

**1202**

**1204**

**1208**

**1214**

**100**

**1206**

**1210**

**1212**

**Fig. 12**

**Fig. 13A**

**Fig. 13B**

**Fig. 13C**

**Fig. 14**

**Fig. 15**

**Fig. 16A**

**Fig. 16B**

**Fig. 17**

Fig. 18

**Fig. 19**

**Fig. 20A**

**Fig. 20C**

**Fig. 20B**

**Fig. 21A**

**Fig. 21B**

**Fig. 21C**

**Fig. 21D**

# Fig. 22

**Fig. 23A**

**Fig. 23B**

**Fig. 24A**

**Fig. 24B**

**Fig. 25**

Fig. 26A

Fig. 26B

**Fig. 27**

**Fig. 28A**

**Fig. 28B**

**Fig. 29**

**Fig. 30**

Fig. 31

**Fig. 32A**

**Fig. 32B**

**Fig. 32C**

**Fig. 32D**

Fig. 33

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 5910940 A
- US 4269170 A
- US 7485799 B
- WO 10424259 A

### Non-patent literature cited in the description

- **J. G. MAVROIDES ; J. A. KAFALAS ; D. F. KOLESAR.** Photoelectrolysis of water in cells with SrTiO3 anodes. *Applied Physics Letters,* 01 March 1976, vol. 28 (5
- **A. FUJISHIMA ; K. HONDA.** *Nature,* 1972, vol. 238, 37
- **O. KHASELEV ; J. TURNER.** A Monolithic Photovoltaic-Photoelectrochemical Device for Hydrogen Production via Water Splitting. *Science,* 17 April 1998, vol. 280
- **P. J. SEBASTIAN ; M. E. CALIXTO ; R. N. BHATTACHARYA.** *Electrodeposited CIS and CIGS thin film photocatalysts for hydrogen production by photoelectrolysis*
- **T. GERFIN ; M. GRAETZEL ; L. WALDER.** Molecular and Supramolecular Surface Modification of Nanocrystalline TiO2 films: Charge-Separating and Charge-Injecting Devices. *Progr. Inorg. Chem.,* 1997, vol. 44, 345-393
- Photon tunneling microscopy applications, MRS Proceedings. **GUERRA, J. M.** Determining Nanoscale Physical Properties of Materials by Microscopy and Spectroscopy. vol. 332, 457
- **GUERRA, J. M. ; D. VEZENOV.** *Method of fabrication of sub-micron spherical micro-lenses,* 04 December 2001
- Embedded nano-optic media for near-field high density optical data storage: modeling, fabrication, and performance. **GUERRA, J. M. et al.** Proceedings, Optical Data Storage Conference. SPIE, April 2001
- **GUERRA, J. M. et al.** Near-field optical recording without low-flying heads. *ISOM Technical Digest,* 2001
- **GUERRA, J. M. et al.** Near-field optical recording without low-flying heads: Integral Near-Field Optical (INFO) Media. *Japanese Journal of Applied Physics,* March 2002
- **J. M. BENNETT et al.** Comparison of the properties of titanium dioxide films prepared by various techniques. *Appl. Opt.,* 1989, vol. 28, 3303-3317
- **H. T. TIEN ; A. L. OTTOVA.** Hydrogen generation from water using semiconductor septum electrochemical photovoltaic (SC-SEP) cells. *Current Topics in Biophysics,* 2000, vol. 25 (1), 39-60
- **M.E. LAW ; S. CEA.** *Comp. Mater. Sci.,* 1998, vol. 12, 289
- **B. E. DEAL ; S. GROVE.** *J. Appl. Phys.,* 1965, vol. 36, 3770